# EUROPEAN PATENT SPECIFICATION

(11) **EP 4 567 432 B1**
(45) Date of publication and mention of the grant of the patent: **12.08.2026**
(21) Application number: 24211047.6
(22) Date of filing: 06.11.2024
(51) Int. Cl.: G01P 1/02, G01P 15/09, G01P 15/18

(54) **METHOD OF MANUFACTURING A PIEZOELECTRIC ACCELERATION SENSOR AND PIEZOELECTRIC ACCELERATION SENSOR OBTAINED BY THIS METHOD**
VERFAHREN ZUR HERSTELLUNG EINES PIEZOELEKTRISCHEN BESCHLEUNIGUNGSSENSORS UND NACH DIESEM VERFAHREN HERGESTELLTER PIEZOELEKTRISCHER BESCHLEUNIGUNGSSENSOR
PROCÉDÉ DE FABRICATION D'UN CAPTEUR D'ACCÉLÉRATION PIÉZOÉLECTRIQUE ET CAPTEUR D'ACCÉLÉRATION PIÉZOÉLECTRIQUE OBTENU PAR CE PROCÉDÉ

(30) Priority: 08.12.2023 US 202363607695 P; 19.01.2024 EP 24152753
(43) Date of publication of application: 11.06.2025
(73) Proprietor: Kistler Holding AG, 8408 Winterthur (CH)
(72) Inventor: Pfluger, Kim, Amherst, NY, 14228 (US); Cook, Andrew Paul, Williamsville, NY, 14221 (US); Wolf, Dan, Niagara Falls, NY, 14304 (US)

(56) References cited:
- CN-U- 214 667 243
- US-A1- 2014 265 740
- US-A1- 2020 379 002
- US-A1- 2022 011 338
- KISTLER: "IEPE Triaxial Piezoelectric Accelerometer Type Kistler 8763B", 1 May 2022 (2022-05-01), pages 1 - 5, XP093171774, Retrieved from the Internet <URL:https://kistler.cdn.celum.cloud/SAPCommerce_Download_original/000-928e.pdf> [retrieved on 20240607]
- WEBER ET AL: "Piezoelectric Accelerometers, Theory and Application", METRA MESS- UND FREQUENZTECHNIK IN RADEBEUL E.K., 1 January 2012 (2012-01-01), pages 7,28 - 29, XP055499540, Retrieved from the Internet <URL:https://www.mmf.de/manual/transducermane.pdf> [retrieved on 20180814]

## Description

### FIELD

The present invention relates to a method of manufacturing a piezoelectric acceleration sensor and to a piezo-electric acceleration sensor obtained by this method.

### BACKGROUND

An acceleration sensor is basically a force sensor with an attached mass. The mechanical quantity measured is a force which is proportional to the acceleration, according to Newton's second law of motion F = m * a. The mass m is usually called seismic mass. A piezoelectric acceleration sensor comprises piezoelectric material which creates electric charge when subjected to a force. The electric charge is proportional to the applied force and can be measured directly by means of electrodes. A piezoelectric acceleration sensor has the advantage of a fast response time of a few µsecs and is thus utilized to measure dynamic oscillations and vibrations on machines and structures.

Such a piezoelectric acceleration sensor is shown in US6397677B1. The piezoelectric acceleration sensor comprises for each sensitive axis one piezoelectric measurement element which consists of a pair of spaced-apart accelerometer halves. For a triaxial piezoelectric acceleration sensor, three sensitive axes are mutually perpendicular to each other. Each accelerometer half comprises first and second plates from piezoelectric material and first and second seismic masses which are clamped by a bolt to a common post. By means of the post, the accelerometer halves are rigidly connected to a body. The accelerometer halves, the posts and the body are enclosed by a housing.

From the data sheet of Kistler: "IEPE Triaxial Piezoelectric Accelerometer Type Kistler 8763B", XP093171774, an IEPE triaxial accelerometer is known.

It is a general requirement to measure fast oscillations and vibrations, for which the piezoelectric acceleration sensor must have a high resonant frequency. And since the resonant frequency of the piezoelectric acceleration sensor is inversely proportional to its weight, the piezoelectric acceleration sensor should have a weight as small as possible.

The plates from piezoelectric material are made from shear type quartz with a nominal force sensitivity of 50 pC/N. To measure such a small electric charge largely without loss, a charge amplifier is built in the housing of the piezoelectric acceleration sensor. The charge amplifier converts the electric charge into an output voltage of typically ±5 V full scale, which can be easily processed further by standard measuring devices. For the conversion of electric charge from each piezoelectric measurement element, one charge amplifier is required. The charge amplifier must be provided with a supply voltage. Thus, the housing of a triaxial piezoelectric acceleration sensor comprises an electric feedthrough to exit the output voltage from three piezoelectric measurement elements and to enter the supply voltage for three charge amplifiers.

To further simplify the further processing of the output voltage, the piezoelectric acceleration sensor often comprises a transducer electronic data sheet (TEDS). TEDS is an IEEE 1451 standard and provides information about the piezoelectric acceleration sensor such as identification data, type designation, calibration data, etc. The TEDS can be read out by an evaluation unit via the electric feedthrough.

A triaxial piezoelectric acceleration sensor with integrated charge amplifier and TEDS is commercially distributed by the applicant and described as "Type 8763B" sensor in the datasheet 8763B_000-928e-05.22, which is herewith integrated by reference. The charge amplifier and the associated electronics of the "Type 8763B" sensor are called integrated electronics piezo-electric (IEPE). The "Type 8763B" sensor has one TEDS for each piezoelectric measurement element. The "Type 8763B" sensor has a hermetic and waterproof housing with a cubic shape and a small side length of 10.9 mm. The housing is made from titanium and has a light weight of 3.6 grams. The electric feedthrough consists of a four-pin connector.

The manufacturing of the "Type 8763B" sensor requires an assembly of three piezoelectric measurement elements, three IEPE, three TEDS and one printed circuit board within the small cubic housing. Strictly speaking, the three piezoelectric measurement elements are welded to the body inside the housing and the printed circuit board is glued to the body. Thereupon, for each sensitive axis, one IEPE and one TEDS are glued to the printed circuit board. Now, electrodes of each piezoelectric measurement element are electrically connected to the corresponding IEPE and to the housing. For each sensitive axis, the IEPE and the TEDS are electrically connected with each other. In addition, electrical connections must be made from the IEPE and the TEDS of each sensitive axis to the four-pin connector. This assembly is costly and error prone.

The object of the present invention is to provide a method of manufacturing a piezoelectric acceleration sensor which is in comparison with the "Type 8763B" sensor cost reduced and less error prone. Present invention also relates to comparatively inexpensive piezoelectric acceleration sensor.

### BRIEF SUMMARY

This object is achieved by the independent claim of present invention.

Present invention relates to a method of manufacturing a piezoelectric acceleration sensor, which piezoelectric acceleration sensor comprises a housing element, a plurality of measuring elements, a flexible printed circuit board element and a connector element, which housing element comprises an inner space and a body element in the inner space, which plurality of measuring elements measures an acceleration along a plurality of sensitive axes and creates a plurality of electric charges for the measured acceleration, which flexible printed circuit board element hosts a plurality of IEPE, each of the plurality of IEPE amplifies and converts electric charge from a related one of the plurality of measuring elements into an output voltage, which flexible printed circuit board element establishes a ground output voltage; the method comprising a step I of introducing the flexible printed circuit board element in the inner space of the housing element and of mechanically fixing the flexible printed circuit board element to the body element; a step II of introducing the plurality of measuring elements in the inner space of the housing element and of mechanically fixing the plurality of measuring elements to the body element; a step III of realizing first electrical connections of each of the plurality of measuring elements with a related one of a plurality of circuit board sections of the flexible printed circuit board element, the number of first electrical connections is equal to the number of the plurality of sensitive axes; and a step IV of realizing further electrical connections of the connector element with a connector section of the flexible printed circuit board element, the number of further electrical connections is equal to the number of the plurality of output voltages, and of mounting the electrically connected connector element on the housing element.

Present invention also relates to a piezoelectric acceleration sensor comprising a housing element with a body element, a plurality of measuring elements, a flexible printed circuit board element and a connector element, which housing element comprises an inner space and a body element in the inner space, which plurality of measuring elements measures an acceleration along a plurality of sensitive axes and creates a plurality of electric charges for the measured acceleration, which plurality of measuring elements is mechanically fixed to the body element, which flexible printed circuit board element hosts a plurality of IEPE, each of the plurality of IEPE amplifies and converts electric charge from a related one of the plurality of measuring elements into an output voltage, which flexible printed circuit board element establishes a ground output voltage, which flexible printed circuit board element is mechanically fixed to the body element; wherein the flexible printed circuit board element comprises a plurality of circuit board sections, each of the circuit board sections hosts one the plurality of IEPE, each of the plurality of measuring elements has a first electrical connection with a related one of the plurality of circuit board sections, the number of first electrical connections is equal to the number of the plurality of sensitive axes; wherein the flexible printed circuit board element comprises a connector section and the connector element has a further electrical connection with the connector section, the number of further electrical connections is equal to the number of the plurality of output voltages.

In comparison with the "Type 8763B" sensor, present invention drastically reduces the number of first electrical connection and of further electrical connections. For a triaxial piezoelectric acceleration sensor, the number of the plurality of sensitive axes is three and, thus, also the number of first electrical connections. And for a triaxial piezoelectric acceleration sensor, the number of the plurality of output voltages is four and, thus, also the number of further electrical connections. In total, a triaxial piezoelectric acceleration sensor according to the invention requires only seven electrical connections in the inner space of the housing element, whereas the "Type 8763B" sensor requires around three times as many electrical connections. Thus, not only the method of manufacturing a piezoelectric acceleration sensor is cost-effective and less error prone, also the manufactured piezoelectric acceleration sensor is less expensive.

Preferred embodiments of the invention are claimed in the dependent claims. In addition, the features of the dependent claims also achieve the object.

### BRIEF DESCRIPTION OF THE EXEMPLARY DRAWINGS

In the following, the invention will be explained in more detail by way of example with reference to the figures, in which:
- Fig. 1: shows a perspective view of a portion of a housing element 10 of a piezoelectric acceleration sensor 1;
- Fig. 2: shows a cross-sectional view of a portion of a plurality of measuring elements 11x, 11y, 11z before being mounted in the housing element 10 of the piezoelectric acceleration sensor 1 of Fig. 1;
- Fig. 3: shows a top view of a portion of a flexible printed circuit board element 12 before being mounted in the housing element 10 of the piezoelectric acceleration sensor 1 of Fig. 1;
- Fig. 4: shows a schematic view of a portion of an electric circuitry of the plurality of measuring elements 11x, 11y, 11z of Fig. 2, the flexible printed cir- cuit board element 12 of Fig. 3 and a connector element 14;
- Fig. 5: shows a perspective of a portion of the flexible printed circuit board element 12 of Fig. 3 after being mounted in the housing element 10 of the piezoelectric acceleration sensor 1 of Fig. 1;
- Fig. 6: shows an explosive view of a portion of the plurality of measuring elements 11x, 11y, 11z of Fig. 2 during mounting in the housing element 10 of the piezoelectric acceleration sensor 1 of Fig. 5;
- Fig. 7: shows a perspective view of a portion of first electrical EC connections of the plurality of measuring elements 11x, 11y, 11z with the flexible printed circuit element 12 of Fig. 6;
- Fig. 8: shows an explosive view of portions of a plurality of cover elements 13x, 13y and of a connector element 14 before being mounted on the housing element 10 of the piezoelectric acceleration sensor 1 of Fig. 7;
- Fig. 9: shows an enlarged view of a portion of further electrical connections FEC of the flexible printed circuit element 12 of Fig. 7 with the connector element 14 of Fig. 8; and
- Fig. 10: shows a perspective view of a portion of the plurality of cover elements 13x, 13y and the connector element 14 of Fig. 8 after being mounted on the housing element 10 of the piezoelectric acceleration sensor 1 of Fig. 8.
Like reference numerals refer to like elements throughout.

### DETAILED DESCRIPTION OF THE EXEMPLARY EMBODIMENTS OF THE INVENTION

### HOUSING ELEMENT 10

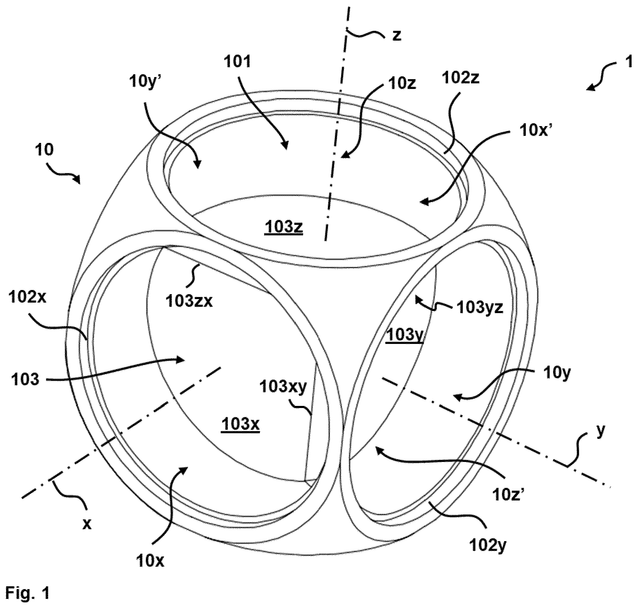

The piezoelectric acceleration sensor 1 comprises a housing element 10. Fig. 1 is a perspective view of a portion of the housing element 10.

The piezoelectric acceleration sensor 1 is arranged in a coordinate system with a plurality of axes x, y, z also referred to as the transverse axis x, the longitudinal axis y and the vertical axis z. Always two of the plurality of axes x, y, z are perpendicular to each other. Preferably, the number of the plurality of axes x, y, z is three.

The housing element 10 has the function to protect the piezoelectric acceleration sensor 1 from harmful environmental impacts such as contamination (dust, moisture, etc.) and from electrical and electromagnetic interference effects in the form of electromagnetic radiation. The housing element 10 is made of mechanically resistant material such as pure metals, titanium alloys, nickel alloys, cobalt alloys, iron alloys, etc.

Preferably, the housing element 10 has a cubic shape with six side faces 10x, 10x', 10y, 10y' 10z, 10z', including:
- A first transverse side face 10x and a second transverse side face 10x' which are oriented normal to the transverse axis x.
- A first longitudinal side face 10y and a second longitudinal side face 10y' which are oriented normal to the longitudinal axis y.
- A first vertical side face 10z and a second vertical side face 10z' which are oriented normal to the vertical axis z.

Preferably, each of the six side faces 10x, 10x', 10y, 10y' 10z, 10z' has a length of less/equal 2 cm. Preferably, the six side faces 10x, 10x', 10y, 10y' 10z, 10z' are formed integrally.

The housing element 10 comprises an inner space 101 which is delimited by the six side faces 10x, 10x', 10y, 10y' 10z, 10z'.

Preferably, the housing element 10 comprises a plurality of housing openings 102x, 102y, 102z, including:
- A transverse housing opening 102x on the first transverse side face 10x to access the inner space 101 from the direction of the transverse axis x.
- A longitudinal housing opening 102y on the first longitudinal side face 10y to access the inner space 101 from the direction of the longitudinal axis y.
- A vertical housing opening 102z on the first vertical side face 10z to access the inner space 101 from the direction of the vertical axis z.

Preferably, the second transverse side face 10x', the second longitudinal side face 10y' and the second vertical side face 10z' are completely closed surfaces. As a result, the inner space 101 is inaccessible from outside the housing element 10 via the second transverse side face 10x', the second longitudinal side face 10y' and the second vertical side face 10z'.

The housing element 10 comprises a body element 103. The body element 103 is arranged in the inner space 101. Preferably, the body element 103 is secured to at least one of the second transverse side face 10x', the second longitudinal side face 10y' and the second vertical side face 10z'. Preferably, the body element 103 is formed integrally with at least one of the second transverse side face 10x', the second longitudinal side face 10y' and the second vertical side face 10z'.

Preferably, the body element 103 has a plurality of surfaces 103x 103y, 103z, including:
- A transverse surface 103x which is oriented normal to the transverse axis x.
- A longitudinal surface 103y which is oriented normal to the longitudinal axis y.
- A vertical surface 103z which is oriented normal to the vertical axis z.

The plurality of surfaces 103x 103y, 103z are accessible from outside the housing element 10 via the plurality of housing openings 102x, 102y, 102z. Each of the plurality of surfaces 103x 103y, 103z is substantially flat.

Two of the plurality of surfaces 103x 103y, 103z are directly adjacent and are separated from each other by a common edge 103xy, 103yz, 103zx, including:
- A first edge 103xy which separates the transverse surface 103x from the longitudinal surface 103y.
- A second edge 103yz which separates the longitudinal surface 103y from the vertical surface 103z. In the perspective view of Fig. 1, the second edge 103yz is hidden by other elements.
- A third edge 103zx which separates the vertical surface 103z from the transverse surface 103x.

### MEASURING ELEMENT 11x, 11z, 11z

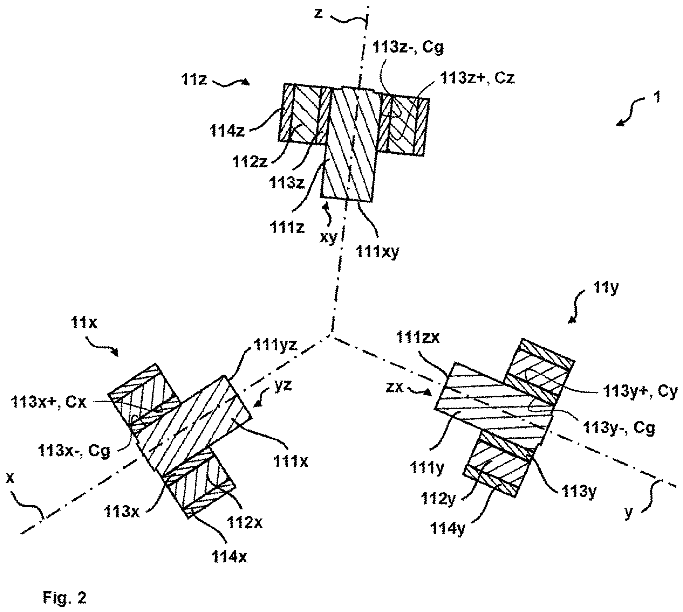

The piezoelectric acceleration sensor 1 comprises a plurality of measuring elements 11x, 11y, 11z. Fig. 2 is a cross-sectional view of a portion of the plurality of measuring elements 11x, 11z, 11z before being mounted in the housing element 10 of the piezoelectric acceleration sensor 1 of Fig. 1.

The plurality of measuring elements 11x, 11y, 11z has the function to create a plurality of electric charges Cx, Cy, Cz and ground charge Cg for an acceleration to be measured. Each of the plurality of electric charges Cx, Cy, Cz is proportional to the acceleration to be measured.

The plurality of measuring elements 11x, 11y, 11z has an identical construction, including:
- A transverse measuring element 11x which measures an acceleration along the transverse axis x and creates transverse electric charge Cx and ground charge Cg for the measured acceleration. The transverse axis x is also called sensitive axis x of the transverse measuring element 11x. The transverse measuring element 11x comprises a transverse post 111x, a transverse seismic mass 112x, a transverse piezoelectric element 113x and a transverse preloading element 114x.
- A longitudinal measuring element 11y which measures an acceleration along the longitudinal axis y and creates longitudinal electric charge Cy and ground charge Cg for the measured acceleration. The longitudinal axis y is also called sensitive axis y of the longitudinal measuring element 11y. The longitudinal measuring element 11y comprises a longitudinal post 111y, a longitudinal seismic mass 112y, a longitudinal piezoelectric element 113y and a longitudinal preloading element 114y.
- A vertical measuring element 11z which measures an acceleration along the vertical axis z and creates vertical electric charge Cz and ground charge Cg for the measured acceleration. The vertical axis z is also called sensitive axis z of the vertical measuring element 11z. The vertical measuring element 11z comprises a vertical post 111z, a vertical seismic mass 112z, a vertical piezoelectric element 113z and a vertical preloading element 114z.

Preferably, the piezoelectric acceleration sensor 1 is a triaxial piezoelectric acceleration sensor and the number of the plurality of sensitive axes x, y, z of the plurality of measuring elements 11x, 11y, 11z is three.

The plurality of posts 111x, 111y, 111z mechanically supports the seismic masses 112x, 112y, 112z, the piezoelectric elements 113x, 113y, 113z and the preloading elements 114x, 114y, 114x. The plurality of posts 111x, 111y, 111z is made of mechanically resistant material such as pure metals, titanium alloys, nickel alloys, cobalt alloys, iron alloys, etc. Preferably, the plurality of posts 111x, 111y, 111z has a cylindrical shape, including:
- The transverse post 111x with a greater extension along the transverse axis x and a smaller extension in a transverse base plane yz which is perpendicular to the transverse axis x. At one end along the transverse axis x, the transverse post 111x has a transverse post surface 111yz which lies in the transverse base plane yz.
- The longitudinal post 111y with a greater extension along the longitudinal axis y and a smaller extension in a longitudinal base plane zx which is perpendicular to the longitudinal axis y. At one end along the longitudinal axis y, the longitudinal post 111y has a longitudinal post surface 111zx which lies in the longitudinal base plane zx.
- The vertical post 111z with a greater extension along the vertical axis z and a smaller extension in a vertical base plane xy which is perpendicular to the vertical axis z. At one end along the vertical axis z, the vertical post 111z has a vertical post surface 111xy which lies in the vertical base plane xy.

The plurality of seismic masses 112x, 112y, 112z is made of high-density material such as iridium, platinum, tungsten, gold, etc. Preferably, the plurality of seismic masses 112x, 112y, 112z has an annular shape, including:
- A transverse seismic mass 112x.
- A longitudinal seismic mass 112y.
- A vertical seismic mass 112z.

The plurality of piezoelectric elements 113x, 113y, 113z is made of piezoelectric material such as quartz, calcium gallo-germanate, langasite, gallium orthophosphate, piezoceramics, etc. The plurality of piezoelectric elements 113x, 113y, 113z has a high sensitivity for the acceleration to be measured. Preferably, the plurality of piezoelectric elements 113x, 113y, 113z has an annular shape, including:
- A transverse piezoelectric element 113x. With respect to a radial direction, which is perpendicular to the transverse axis x, the transverse piezoelectric element 113x lies radially outside the transverse post 111x and radially inside the transverse seismic mass 112x. Under the effect of an acceleration, the transverse seismic mass 112x exerts a force which is proportional to its acceleration onto the transverse piezoelectric element 113x. The force is exerted in radial direction. Preferably, the transverse piezoelectric element 113x exploits the piezoelectric shear effect and creates transverse electric charge Cx and ground charge Cg for the exerted force.
- A longitudinal piezoelectric element 113y. With respect to a radial direction, which is perpendicular to the longitudinal axis y, the longitudinal piezoelectric element 113y lies radially outside the longitudinal post 111y and radially inside the longitudinal seismic mass 112y. Under the effect of an acceleration, the longitudinal seismic mass 112y exerts a force which is proportional to its acceleration onto the longitudinal piezoelectric element 113y. The force is exerted in radial direction. Preferably, the longitudinal piezoelectric element 113y exploits the piezoelectric shear effect and creates longitudinal electric charge Cy and ground charge Cg for the exerted force.
- A vertical piezoelectric element 113z. With respect to a radial direction, which is perpendicular to the vertical axis z, the vertical piezoelectric element 113z lies radially outside the vertical post 111z and radially inside the vertical seismic mass 112z. Under the effect of an acceleration, the vertical seismic mass 112z exerts a force which is proportional to its acceleration onto the vertical piezoelectric element 113z. The force is exerted in radial direction. Preferably, the vertical piezoelectric element 113z exploits the piezoelectric shear effect and creates vertical electric charge Cz and ground charge Cg for the exerted force.

The plurality of preloading elements 114x, 114y, 114z is made of mechanically resistant material such as pure metals, titanium alloys, nickel alloys, cobalt alloys, iron alloys, etc. Preferably, the plurality of preloading elements 114x, 114y, 114z has an annular shape, including:
- A transverse preloading element 114x which lies with respect to the radial direction, which is perpendicular to the transverse axis x, radially outside the transverse seismic mass 112x. The transverse preloading element 114x preloads the transverse seismic mass 112x and the transverse piezoelectric element 113x against the transverse post 111x.
- A longitudinal preloading element 114y which lies with respect to the radial direction, which is perpendicular to the longitudinal axis y, radially outside the longitudinal seismic mass 112y. The longitudinal preloading element 114y preloads the longitudinal seismic mass 112y and the longitudinal piezoelectric element 113y against the longitudinal post 111y.
- A vertical preloading element 114z which lies with respect to the radial direction, which is perpendicular to the vertical axis z, radially outside the vertical seismic mass 112z. The vertical preloading element 114z preloads the vertical seismic mass 112z and the vertical piezoelectric element 113z against the vertical post 111z.

The plurality of piezoelectric elements 113x, 113y, 113z comprise a plurality of faces 113x+, 113y+, 113z+, 113x-, 113y-, 113z-, including:
- The transverse piezoelectric element 113x comprises a transverse face 113x+, where transverse electric charge Cx is created for an acceleration. The transverse seismic mass 112x is applied on the transverse face 113x+ and collects the transverse electric charge Cx. Due to the mechanic preloading, the transverse seismic mass 112x is electrically connected with the transverse preloading element 114x.
- The longitudinal piezoelectric element 113y comprises a longitudinal face 113y+, where longitudinal electric charge Cy is created for an acceleration. The longitudinal seismic mass 112y is applied on the longitudinal face 113y+ and collects the longitudinal electric charge Cy. Due to the mechanic preloading, the longitudinal seismic mass 112y is electrically connected with the longitudinal preloading element 114y.
- The vertical piezoelectric element 113z comprises a vertical face 113z+, where vertical electric charge Cz is created for an acceleration. The vertical seismic mass 112z is applied on the vertical face 113z+ and collects the vertical electric charge Cz. Due to the mechanic preloading, the vertical seismic mass 112z is electrically connected with the vertical preloading element 114z.
- The transverse piezoelectric element 113x comprises a ground transverse face 113x-, where ground electric charge Cg is created for the acceleration. The transverse post 111x is applied on the ground transverse face 113x- and collects the ground electric charge Cg.
- The longitudinal piezoelectric element 113y comprises a ground longitudinal face 113y-, where ground electric charge Cg is created for the acceleration. The longitudinal post 111y is applied on the ground longitudinal face 113y- and collects the ground electric charge Cg.
- The vertical piezoelectric element 113z comprises a ground vertical face 113z-, where ground electric charge Cg is created for the acceleration. The vertical post 111z is applied on the ground vertical face 113z- and collects the ground electric charge Cg.

### FLEXIBLE PRINTED CIRCUIT BOARD ELEMENT 12

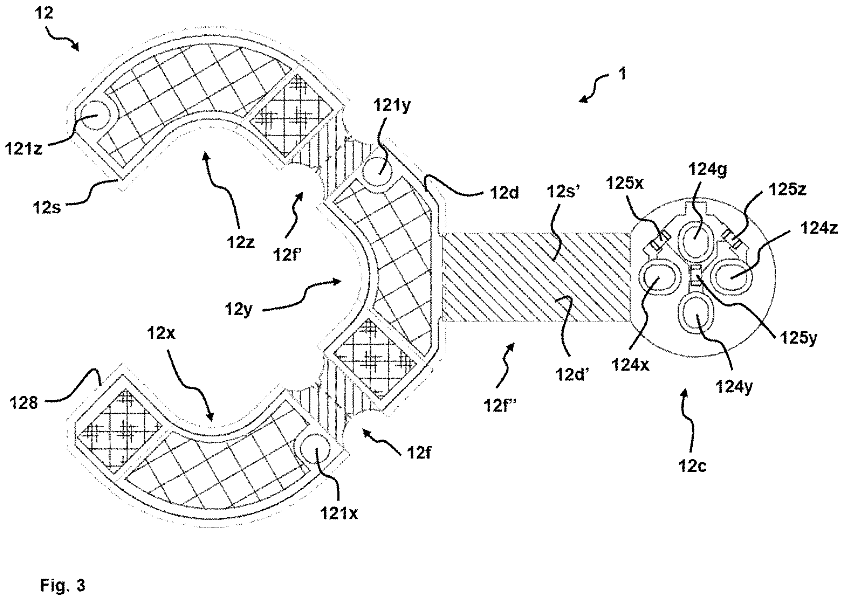

The piezoelectric acceleration sensor 1 comprises a flexible printed circuit board element 12. Fig. 3 is a top view of a portion of the flexible printed circuit board element 12 before being mounted in the housing element 10 of the piezoelectric acceleration sensor 1 of Fig. 1.

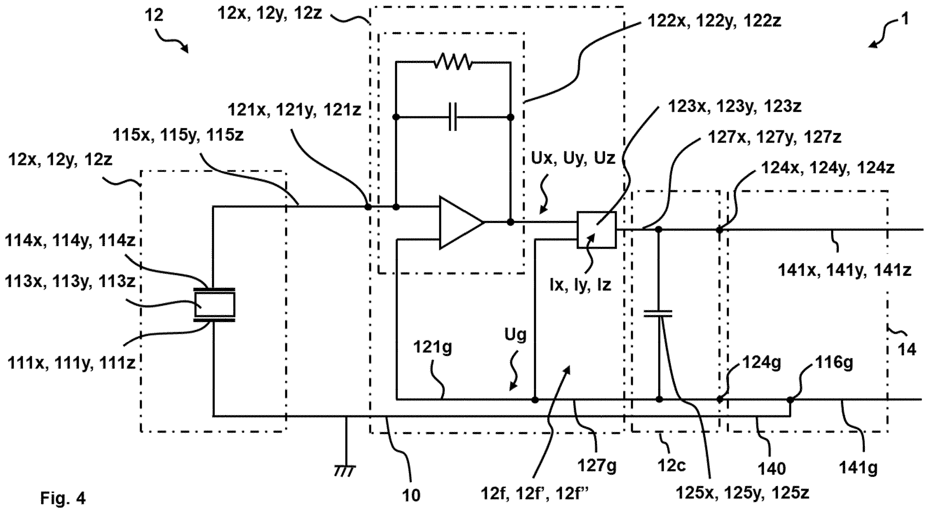

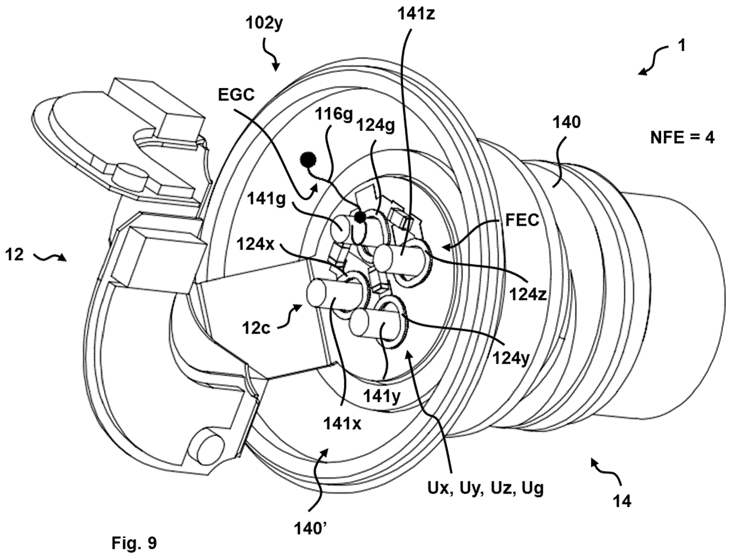

Fig. 4 is a schematic view of a portion of the electric circuitry of the plurality of measuring elements 11x, 11y, 11z of Fig. 2, the flexible printed circuit board element 12 of Fig. 3 and a connector element 14 of Fig. 9.

The flexible printed circuit board element 12 has the primary function to host a plurality of IEPE 122x, 122y, 122z. The plurality of IEPE 122x, IEPE 122y, IEPE 122z has an identical construction, including:
- A transverse IEPE 122x which amplifies and converts transverse electric charge Cx from the transverse seismic mass 112x of the transverse measuring element 11x into a transverse output voltage Ux. The transverse seismic mass 112x is electrically connected to an IEPE input of the transverse IEPE 122x. The transverse output voltage Ux is available at an IEPE output of the transverse IEPE 122x. The transverse IEPE 122x has a ground output.
- A longitudinal IEPE 122y which amplifies and converts longitudinal electric charge Cy from the longitudinal seismic mass 112y of the longitudinal measuring element 11y into a longitudinal output voltage Uy. The longitudinal seismic mass 112y is electrically connected to an IEPE input of the longitudinal IEPE 122y. The longitudinal output voltage Uy is available at an IEPE output of the longitudinal IEPE 122y. The longitudinal IEPE 122y has a ground output.
- A vertical IEPE 122z which amplifies and converts vertical electric charge Cz from the vertical seismic mass 112z of the vertical measuring element 11z into a vertical output voltage Uz. The vertical seismic mass 112z is electrically connected to an IEPE input of the vertical IEPE 122z. The vertical output voltage Uz is available at an IEPE output of the vertical IEPE 122z. The vertical IEPE 122z has a ground output.
In the sense of the present invention the adjective "related" has the meaning of "functionally dedicated". The relationship goes in both directions. In the case at hand, each of the plurality of IEPE 122x, 122y, 122z is made for a related one of the plurality of measuring elements 11x, 11y, 11z and electric charge Cx, Cy, Cz from each of the plurality of measuring elements 11x, 11y, 11z is transmitted to a related one of the plurality of IEPE 122x, 122y, 122z.

The flexible printed circuit board element 12 has the secondary function to host a plurality of TEDS 123x, 123y, 123z, including:
- A transverse TEDS 123x with stored transverse information Ix about a related transverse measuring element 11x such as identification data, type designation, calibration data, etc.
- A longitudinal TEDS 123y with stored longitudinal information Iy about a related longitudinal measuring element 11y such as identification data, type designation, calibration data, etc.
- A vertical TEDS 123z with stored vertical information Iz about a related vertical measuring element 11z such as identification data, type designation, calibration data, etc.

The plurality of TEDS 123x, TEDS 123y, TEDS 123z has an identical construction. Each of the plurality of TEDS 123x, TEDS 123y, TEDS 123z has a TEDS input, a TEDS output, a storage element and a ground output. Preferably, the IEPE output of each of the plurality of IEPE 122x, IEPE 122y, IEPE 122z is directly electrically connected with a TEDS input of a related one of the plurality of TEDS 123x, TEDS 123y, TEDS 123z. The information Ix, Iy, Iz stored in the storage element of each of the plurality of TEDS 123x, TEDS 123y, TEDS 123z as well as the output voltage Ux, Uy, Uz of each of the plurality of IEPE 122x, IEPE 122y, IEPE 122z are available at the TEDS output of each of the plurality of TEDS 123x, TEDS 123y, TEDS 123z.

The flexible printed circuit board element 12 comprises a plurality of circuit board sections 12x, 12y, 12z, including:
- A transverse circuit board section 12x which is related with the transverse measuring element 11x. The transverse circuit board section 12x comprises a transverse connection site 121x for a first electrical connection with the transverse measuring element 11x. The transverse circuit board section 12x comprises a ground connector 121g which is electrically connected with the ground output of the transverse IEPE 122x. The transverse circuit board section 12x comprises the transverse IEPE 122x with a charge amplifier and associated electronics. The transverse connection site 121x is electrically connected with the IEPE input of the transverse IEPE 122x. Optionally, the transverse circuit board section 12x comprises the transverse TEDS 123x. The transverse TEDS 123x is related with the transverse IEPE 122x. The ground output of the transverse TEDS 123x is electrically connected with the ground connector 121g.
- A longitudinal circuit board section 12y which is related with the longitudinal measuring element 11y. The longitudinal circuit board section 12y comprises a longitudinal connection site 121y for a first electrical connection with the longitudinal measuring element 11y. The longitudinal circuit board section 12y comprises a ground connector 121g which is electrically connected with the ground output of the longitudinal IEPE 122y. The longitudinal circuit board section 12y comprises the longitudinal IEPE 122y with a charge amplifier and associated electronics. The longitudinal connection site 121y is electrically connected with the IEPE input of the longitudinal IEPE 122y. Optionally, the longitudinal circuit board section 12x comprises the longitudinal TEDS 123y. The longitudinal TEDS 123y is related with the longitudinal IEPE 122y. The ground output of the longitudinal TEDS 123y is electrically connected with the ground connector 121g.
- A vertical circuit board section 12z which is related with the vertical measuring element 11z. The vertical circuit board section 12z comprises a vertical connection site 121z for a first electrical connection with the vertical measuring element 11z. The vertical circuit board section 12z comprises a ground connector 121g which is electrically connected with the ground output of the vertical IEPE 122z. The vertical circuit board section 12z comprises the vertical IEPE 122z with a charge amplifier and associated electronics. The vertical connection site 121z is electrically connected with the IEPE input of the vertical IEPE 122z. Optionally, the vertical circuit board section 12z comprises the vertical TEDS 123z. The vertical TEDS 123z is related with the vertical IEPE 122z. The ground output of the vertical TEDS 123z is electrically connected with the ground connector 121g.

The ground connector 121g establishes a ground output voltage Ug of the flexible printed circuit board element 12.

The plurality of output voltages Ux, Uy, Uz, Ug is electrically conducted to an evaluation unit which is outside the housing element 10 of the piezoelectric acceleration sensor 1. The evaluation unit is not shown in the drawings. For a high accuracy of the acceleration measurement, the evaluation unit differentiates each of the transverse output voltage Ux, the longitudinal output voltage Uy and the vertical output voltage Uz with the ground output voltage Ug. Preferably, the piezoelectric acceleration sensor 1 is a triaxial piezoelectric acceleration sensor and the number of the plurality of output voltages Ux, Uy, Uz, Ug is four.

The flexible printed circuit board element 12 comprises a connector section 12c which is related with the connector element 14. The connector section 12c comprises a plurality of connection areas 124x, 124y, 124z, 124g, including:
- A transverse connection area 124x for a further electrical connection with the connector element 14.
- A longitudinal connection area 124y for a further electrical connection with the connector element 14.
- A vertical connection area 124z for a further electrical connection with the connector element 14.
- A ground connection area 124g for a further electrical connection with the connector element 14.

Preferably, the connector section 12c comprises a plurality of electro-static discharge protectors 125x, 125y, 125z which are capacitors which increase the capacitance at the connection areas 124x, 124y, 124z, 124g, including:
- A transverse electro-static discharge protector 125x which is electrically connected in parallel with the transverse connection area 124x and the ground connection area 124g.
- A longitudinal electro-static discharge protector 125y which is electrically connected in parallel with the longitudinal connection area 124y and the ground connection area 124g.
- A vertical electro-static discharge protector 125z which is electrically connected in parallel with the vertical connection area 124z and the ground connection area 124g.

Each of the circuit board section 12x, 12y, 12z and the connector section 12c comprise a circuit board substrate 12s of electrically insulating material such as fiber-reinforced polymer with fibers from glass, carbon, aramid, etc. and polymers from epoxy, vinyl ester, polyester thermosetting plastic, etc.

The circuit board substrate 12s has a two-dimensional substrate surface 12d. Preferably, the circuit board substrate 12s has an elevated stiffness and has a flexural strength of greater/equal 300 MPa.

The flexible printed circuit board element 12 comprises a plurality of flexible sections 12f, 12f', 12f", including:
- A first flexible section 12f which flexibly links the transverse circuit board section 12x with the longitudinal circuit board section 12y.
- A second flexible section 12f' which flexibly links the vertical circuit board section 12z with the longitudinal circuit board section 12y.
- A third flexible section 12f'' which flexibly links the longitudinal circuit board section 12y with the connector section 12c.

Each flexible section 12f, 12f', 12f'' comprises a flexible substrate 12s' of electrically insulating material such as polyimide, polytetrafluoroethylene, polyether ether ketone, etc.

The flexible substrate 12s' has a two-dimensional flexible substrate surface 12d'. Preferably, the flexible substrate 12s' is easy to bend and has a flexural strength of less/equal 200 MPa.

Each of the flexible sections 12f, 12f', 12f'' comprises at least two electric conductors 127x, 127y, 127z, 127g including:
- A transverse electric conductor 127x which electrically connects the IEPE output of the transverse IEPE 122x with the transverse connection area 124x such that the transverse output voltage Ux is electrically conducted to the transverse connection area 124x.
- A longitudinal electric conductor 127y which electrically connects the IEPE output of the longitudinal IEPE 122y with the longitudinal connection area 124y, such that the longitudinal output voltage Uy is electrically conducted to the longitudinal connection area 124y.
- A vertical electric conductor 127z which electrically connects the IEPE output of the vertical IEPE 122z with the vertical connection area 124z such that the vertical output voltage Uz is electrically conducted to the vertical connection area 124z.
- A ground electric conductor 127g which electrically connects the ground connector 121g of each of the plurality of circuit board sections 12x, 12y, 12z with the ground connection area 124g such that the ground output voltage Ug is electrically conducted to the ground connection area 124g.

Each of the electric conductors 127x, 127y, 127z, 127g is made of electrically conductive material such as copper, copper alloys, etc.

The flexible printed circuit board element 12 comprises a substantially flat underside 128. Each of the circuit board sections 12x, 12y, 12z comprise an underside 128. Preferably, the underside 128 expands over each of the plurality of circuit board sections 12x, 12y, 12z.

### COVER ELEMENTS 13x, 13z

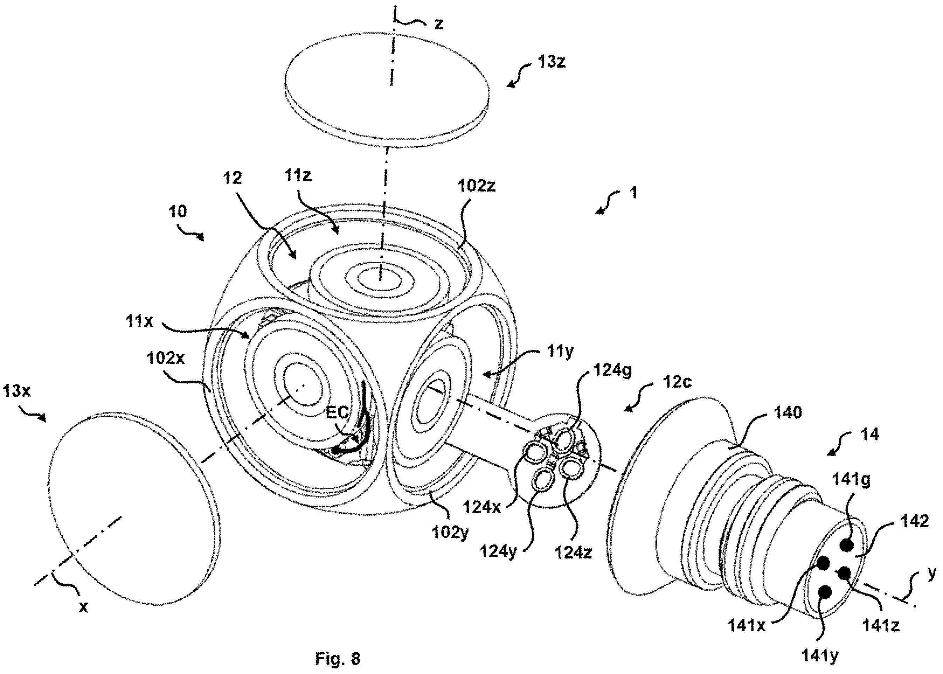

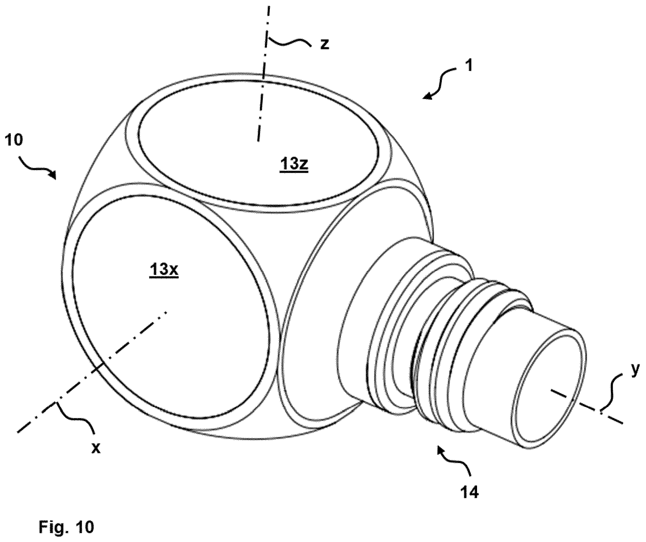

The piezoelectric acceleration sensor 1 comprises a plurality of cover elements 13x, 13z. The Figs. 8 and 10 show portions of the plurality of cover elements 13x, 13z in an explosive view and a perspective view respectively.

The plurality of cover elements 13x, 13z include a transverse cover element 13x and a vertical cover element 13z. The transverse cover element 13x has the function to hermetically close the transverse housing opening 102x of the housing 10. The vertical cover element 13z has the function to hermetically close the vertical housing opening 102z of the housing 10.

The plurality of cover elements 13x, 13z are made of mechanically resistant material such as pure metals, titanium alloys, nickel alloys, cobalt alloys, iron alloys, etc. The plurality of cover elements 13x, 13z have an identical construction.

### CONNECTOR ELEMENT 14

The piezoelectric acceleration sensor 1 comprises a connector element 14. The Figs. 8 to 10 show portions of the connector element 14 in an explosive view, an enlarged view and a perspective view respectively. The connector element 14 comprises a connector housing element 140, a plurality of electric connector conductors 141x, 141y, 141z, 141g and an electric insulation element 142.

The connector housing element 140 has the function to mechanically fix the plurality of electric connector conductors 141x, 141y, 141z, 141g and the electric insulation element 142 in the longitudinal housing opening 102y of the housing element 10 and to hermetically close the longitudinal housing opening 102y of the housing element 10.

The connector housing element 140 is made of mechanically resistant material such as pure metals, titanium alloys, nickel alloys, cobalt alloys, iron alloys, etc.

The connector housing element 140 comprises a connector housing through hole 140' for an insertion of the electric insulation element 142 and a mechanic fixation of the inserted electric insulation element 142. Preferably, this mechanic fixation is obtained by material bonding such as soldering, adhesive bonding, etc.

The plurality of electric connector conductors 141x, 141y, 141z, 141g have the function to electrically conduct the plurality of output voltages Ux, Uy, Uz, Ug from the inner space 101 to the evaluation unit which is outside the housing element 10. The plurality of electric connector conductors 141x, 141y, 141z, 141g are made of electrically conductive material such as copper, copper alloys, etc., comprising:
- A transverse electric connector conductor 141x for electrically conducting the transverse output voltage Ux.
- A longitudinal electric connector conductor 141y for electrically conducting the longitudinal output voltage Uy.
- A vertical electric connector conductor 141z for electrically conducting the vertical output voltage Uz.
- A ground electric connector conductor 141g for electrically conducting the ground output voltage Ug.

The electric insulation element 142 has the function to mechanically fix the plurality of electric connector conductors 141x, 141y, 141z, 141g and to electrically insulate the plurality of electric connector conductors 141x, 141y, 141z, 141g from each other and from the connector housing element 140. The electric insulation element 142 is made of electrically insulating material such as Al₂O₃, ceramics, Al₂O₃ ceramics, etc.

Preferably, the mechanic fixation of the inserted plurality of electric connector conductors 141x, 141y, 141z, 141g with the electric insulation element 142 is obtained by material bonding such as soldering, adhesive bonding, etc.

### STEP I

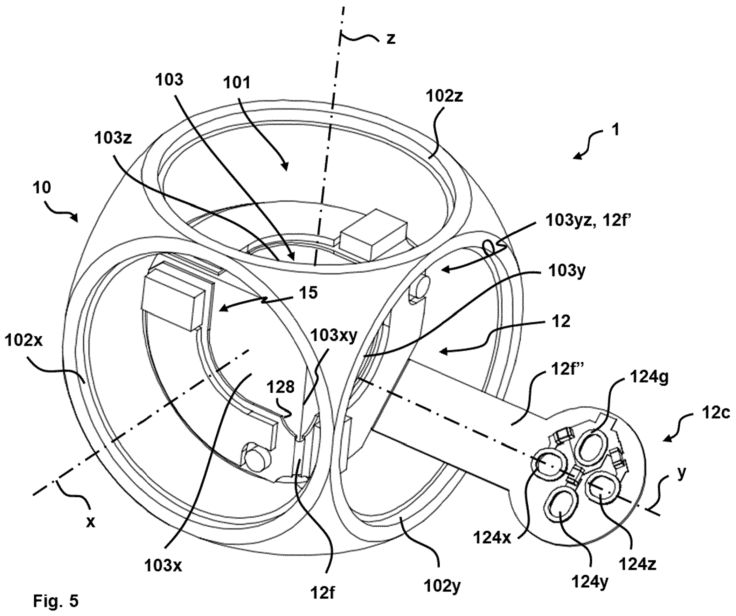

Fig. 5 is a perspective of a portion of the flexible printed circuit board element 12 of Fig. 3 after being mounted in the housing element 10 of the piezoelectric acceleration sensor of Fig. 1.

In step I, the flexible printed circuit board element 12 is introduced via one of the plurality of housing openings 102x, 102y, 102z in the inner space 101.

The so introduced flexible printed circuit board element 12 is mechanically fixed to the body element 103. The mechanic fixation is obtained by material bonding such as welding, soldering, adhesive bonding, etc. The mechanic fixation is realized via a fixation means 15. Preferably, the mechanic fixation is obtained by adhesive bonding and the fixation means 15 consists of an adhesive such as epoxy, polyurethane, cyanoacrylate, methyl methacrylate, etc. The adhesive can be cured to obtain the mechanic end strength of the adhesive bonding. Preferably, the fixation means 15 is electrically conducting.

Prior to the introduction of the flexible printed circuit board element 12 in the inner space 101, the fixation means 15 is applied on the plurality of surfaces 103x, 103y, 103z of the body element 103.

In step I, the introduced flexible printed circuit board element 12 is mechanically contacted with the applied fixation means 15. This mechanic contact is realized via the underside 128 of the flexible printed circuit board element 12 such that:
- The underside 128 of the transverse circuit board section 12x is mechanically contacted with the fixation means 15 which is applied on the transverse surface 103x of the body element 103.
- The underside 128 of the longitudinal circuit board section 12y is mechanically contacted with the fixation means 15 which is applied on the longitudinal surface 103y of the body element 103.
- The underside 128 of the vertical circuit board section 12z is mechanically contacted with the fixation means 15 which is applied on the vertical surface 103z of the body element 103.
- The first flexible section 12f is bent and crosses the first edge 103xy.
- The second flexible section 12f' is bent and crosses the second edge 103yz. In the perspective view of Fig. 5, the second edge 103yz and the second flexible section 12f' are hidden by other elements.
The third flexible section 12f'' is bent and the connector section 12c reaches through the longitudinal housing opening 102y towards the outside of the housing element 10.

In step I, after the realization of the mechanic contact of the flexible printed circuit board element 12 with the applied fixation means 15, the fixation means 15 is cured to obtain the mechanic end strength of the adhesive bonding. The transverse circuit board section 12x is mechanically fixed to the transverse surface 103x, the longitudinal circuit board section 12y is mechanically fixed to the longitudinal surface 103y and the vertical circuit board section 12z is mechanically fixed to the vertical surface 103z. The mechanic fixation is realized via the applied fixation means 15. The mounting of the flexible printed circuit board element 12 in the housing element 10 is accomplished.

### STEP II

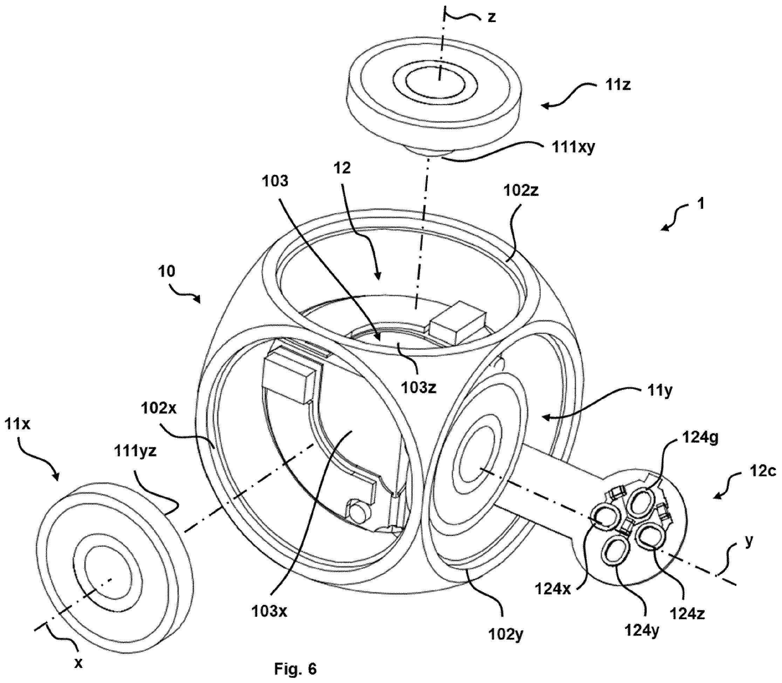

Fig. 6 is an explosive view of a portion of a plurality of measuring elements 11x, 11y, 11z of Fig. 2 during mounting in the housing element 10 of the piezoelectric acceleration sensor 1 of Fig. 5.

In step II, the transverse measuring element 11x is introduced via the transverse housing opening 102x in the inner space 101, the longitudinal measuring element 11y is introduced via the longitudinal housing opening 102y in the inner space 101 and the vertical measuring element 11z is introduced via the vertical housing opening 102z in the inner space 101.

In step II, the introduced measuring elements 11x, 11y, 11z are mechanically contacted with the body element 103. The mechanic contact is realized such that:
- The transverse post surface 111yz of the transverse post 111x of the transverse measuring element 11x is mechanically contacted with the related transverse surface 103x of the body element 103. In the perspective view of Fig. 6, the transverse post surface 111yz is hidden by other elements. Due to the mechanical contact, the ground transverse face 113x- of the transverse measuring element 11x is electrically connected with the housing element 10 such that the ground electric charge Cg of the transverse measuring element 11x is electrically conducted to the housing element 10.
- The longitudinal post surface 111zx of the longitudinal post 111y of the longitudinal measuring element 11y is mechanically contacted with the related longitudinal surface 103y of the body element 103. In the perspective view of Fig. 6, the longitudinal post surface 111zx and the longitudinal surface 103y are hidden by other elements. Due to the mechanical contact, the ground longitudinal face 113y- of the longitudinal measuring element 11y is electrically connected with the housing element 10 such that the ground electric charge Cg of the longitudinal measuring element 11y is electrically conducted to the housing element 10.
- The vertical post surface 111xy of the vertical post 111z of the vertical measuring element 11z is mechanically contacted with the related vertical surface 103z of the body element 103. Due to the mechanical contact, the ground vertical face 113z- of the vertical measuring element 11z is electrically connected with the housing element 10 such that the ground electric charge Cg of the vertical measuring element 11z is electrically conducted to the housing element 10.

As a consequent, in step II, the faces 113x-, 113y-, 113z- of the plurality of measuring elements 11x, 11y, 11z and the housing element 10 possess the same electrical potential.

In step II, after the realization of the mechanic contacts of each of the measuring elements 11x, 11y, 11z with the body element 103, the mechanic contacts are mechanically fixed. The transverse measuring element 11x is mechanically fixed to the transverse surface 103x, the longitudinal measuring element 11y is mechanically fixed to the longitudinal surface 103y and the vertical measuring element 11z is mechanically fixed to the vertical surface 103z. This mechanic fixation is obtained by material bonding such as welding, soldering, adhesive bonding, etc. Preferably, this mechanic fixation is obtained by welding the post surfaces 111yz, 111zx, 111xy of the posts 111x, 111y, 111z of each of the measuring elements 11x, 11y, 11z to related surface 103x, 103y, 103z. Preferably, the welding occurs by resistance welding.

### STEP III

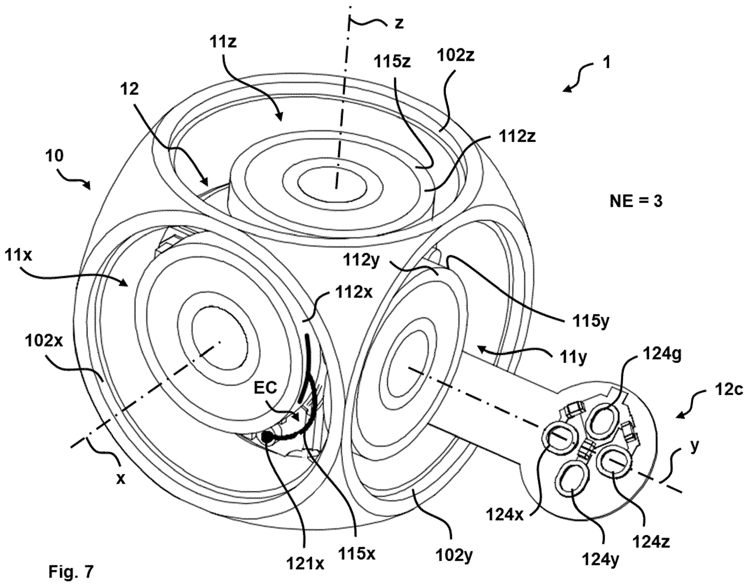

Fig. 7 is a perspective view of a portion of first electrical connections EC of the plurality of measuring elements 11x, 11y, 11z with the flexible printed circuit element 12 of Fig. 6.

In step III, the plurality of measuring elements 11x, 11y, 11z is electrically connected with a connection site 121x, 121y, 121z of a related circuit board section 12x, 12y, 12z. For these first electrical connections EC, a plurality of measuring element wires 115x, 115y, 115z is provided, including:
- The transverse measuring element 11x is electrically connected by means of a transverse measuring element wire 115x with a transverse connection site 121x of a related transverse circuit board section 12x. Preferably, the transverse measuring element wire 115x is electrically connected with the transverse preloading element 114x of the transverse measuring element 11x.
- The longitudinal measuring element 11y is electrically connected by means of a longitudinal measuring element wire 115y with a longitudinal connection site 121y of a related longitudinal circuit board section 12y. Preferably, the longitudinal measuring element wire 115y is electrically connected with the longitudinal preloading element 114y of the longitudinal measuring element 11y. In the perspective view of Fig. 7, the longitudinal connection site 121y, the longitudinal measuring element wire 115y and the longitudinal preloading element 114y are hidden by other elements.
- The vertical measuring element 11z is electrically connected by means of a vertical measuring element wire 115z with a vertical connection site 121z of a related vertical circuit board section 12z. Preferably, the vertical measuring element wire 115z is electrically connected with the vertical preloading 114z of the vertical measuring element 11z. In the perspective view of Fig. 7, the vertical connection site 121z, the vertical measuring element wire 115z and the vertical preloading element 114z are hidden by other elements.

The number of first electrical connections NE of the plurality of measuring elements 11x, 11y, 11z with the plurality of circuit board sections 12x, 12y, 12z is equal to the number of the plurality of sensitive axes x, y, z. Preferably, for a number of the plurality of sensitive axes x, y, z, of three, the number of first electrical connections NE is three.

The plurality of measuring element wires 115x, 115y, 115z is made of electrically conductive material such as copper, copper alloys, etc. Preferably, the electrical connection EC of the plurality of measuring element wires 115x, 115y, 115z with the plurality of measuring elements 11x, 11y, 11z and the plurality of connection sites 121x, 121y, 121z is obtained by material bonding such as wire bonding, thermocompression bonding, thermosonic ball wedge bonding, ultrasonic wedge bonding, etc.

### STEP IV

Fig. 8 is an explosive view of portions of the plurality of cover elements 13x, 13z and of the connector element 14 before being mounted in the housing element 10 of the piezoelectric acceleration sensor 1 of Fig. 7.

In step IV, the transverse cover element 13x is mounted on the transverse housing opening 102x of the housing element 10 such that the transverse housing opening 102x is closed by the transverse cover element 13x and the vertical cover element 13z is mounted on the vertical housing opening 102z of the housing element 10 such that the vertical housing opening 102z is closed by the vertical cover element 13z.

Fig. 9 is an enlarged view of a portion of further electrical connections FEC of the flexible printed circuit element 12 of Fig. 7 with the connector element 14 of Fig. 8.

In step IV, in order to realize the further electrical connections FEC, the connector housing element 140 is placed outside the longitudinal housing opening 102y of the housing element 10 where the connector section 12c reaches through the longitudinal housing opening 102y towards the outside of the housing element 10. The plurality of connection areas 124x, 124y, 124z, 124g of the connector section 12c is mechanically contacted with the plurality of electric connector conductors 141x, 141y, 141z, 141g of the connector element 14. The mechanic contact is realized such that:
- The transverse connection area 124x is mechanically contacted with the transverse electric connector conductor 141x 124x such that the transverse output voltage Ux is electrically conducted to the evaluation unit which outside the housing element 10.
- The longitudinal connection area 124y is mechanically contacted with the longitudinal electric connector conductor 141y such that the longitudinal output voltage Uy is electrically conducted to the evaluation unit which is outside the housing element 10.
- The vertical connection area 124z is mechanically contacted with the vertical electric connector conductor 141z such that the vertical output voltage Uz is electrically conducted to the evaluation unit which is outside the housing element 10.
- The ground connection area 124g is mechanically contacted with the ground electric connector conductor 141g. such that the ground output voltage Ug is electrically conducted to the evaluation unit which is outside the housing element 10.

In step IV, after the realization of the mechanic contacts of the plurality of connection areas 124x, 124y, 124z, 124g with the plurality of electric connector conductors 141x, 141y, 141z, 141g, the mechanic contacts are further electrically connected. These further electrical connections FEC are obtained by material bonding such as wire bonding, thermocompression bonding, thermosonic ball wedge bonding, ultrasonic wedge bonding, etc.

The number of further electrical connections NFE of the plurality of connection areas 124x, 124y, 124z, 124g with the plurality of electric connector conductors 141x, 141y, 141z, 141g is equal to the number of the plurality of output voltages Ux, Uy, Uz, Ug. Preferably, for a number of the plurality of output voltages Ux, Uy, Uz, Ug of four, the number of further electrical connections NFE is four.

In step IV, a ground housing wire 116g is provided. The housing ground wire 116g is made of electrically conductive material such as copper, copper alloys, etc. An electrical ground connection EGC is realized by electrically connecting the connector housing element 140 by means of the ground housing wire 116g with the ground electric connector conductor 141g. Preferably, the electrical ground connection EGC is obtained by material bonding such as wire bonding, thermocompression bonding, thermosonic ball wedge bonding, ultrasonic wedge bonding, etc.

In step IV, once the further electrical connections FEC of the plurality of connection areas 124x, 124y, 124z, 124g with the plurality of electric connector conductors 141x, 141y, 141z, 141g is accomplished, and once the electrical ground connection EGC of the connector housing element 140 with the ground electric connector conductor 141g is accomplished, the connector section 12c is pushed through the vertical housing opening 102z in the inner space 101 of the housing element 10 and the connector housing element 140 is mounted on the vertical housing opening 102z such that the vertical housing opening 102z is closed by the connector housing element 140.

Fig. 10 is a perspective view of a portion of the plurality of cover elements 13x, 13y and the connector element 14 of Fig. 8 after being mounted in the housing element 10 of the piezoelectric acceleration sensor 1 of Fig. 8.

In step IV, the hermetic closure of the plurality of housing openings 102x, 102y, 102z is obtained by material bonding such as welding, soldering, adhesive bonding, etc. As shown in Fig. 10, the hermetic closure is preferably obtained by welding the mounted transverse cover element 13x to the transverse housing opening 102x, by welding the mounted longitudinal cover element 103y to the longitudinal housing opening 102y and by welding the mounted connector housing element 140 to the vertical housing opening 102z. The hermetic closure of the mounted plurality of housing openings 102x, 102y, 102z is accomplished.

As a consequent, in step IV, due to the welding of the mounted connector housing element 140 to the vertical housing opening 102z of the housing element 10, the connector housing element 140 and the housing element 10 possess the same electrical potential. Just as the housing element 10 and the faces 113x-, 113y-, 113z- of the plurality of measuring elements 11x, 11y, 11z possess the same electrical potential and just as the ground connector 121g, the ground electric conductor 127g, the ground connection area 124g and the ground electric connector conductor 141g possess the same electrical potential, as a consequent, the ground output voltage Ug is common to the housing element 10, the plurality of measuring elements 11x, 11y, 11z, the flexible printed circuit board element 12 and the connector element 14. Through it, the piezoelectric acceleration sensor 1, has no electric potential differences.

While exemplary embodiments have been disclosed hereinabove, the present invention is not limited to the disclosed embodiments. Instead, present invention covers any variations, uses, or adaptations of this disclosure using its general principles. Further, the present invention is intended to cover such departures from this disclosure as come within known or customary practice in the art to which the present invention pertain and which fall within the limits of the appended claims.

Thus, the present invention is not limited to the embodiment of electrical ground connection EGC of the connector housing element 140 by means of the ground housing wire 116g with the ground electric connector conductor 141g. The man skilled in the art may realize a different kind of electrical ground connection between the housing element, the plurality of measuring elements, the flexible printed circuit board element and the connector element such as an electrical ground connection between the ground connector or the ground electric conductor of the flexible printed circuit board element with the housing element.

### LIST OF REFERENCE NUMERALS

- 1: piezoelectric acceleration sensor
- 10: housing element
- 10x, 10x': transverse side face
- 10y, 10y': longitudinal side face
- 10z, 10z': vertical side face
- 101: inner space
- 102x: transverse housing opening
- 102y: longitudinal housing opening
- 102z: vertical housing opening
- 103: body element
- 103x: transverse surface
- 103y: longitudinal surface
- 103z: vertical surface
- 103xy: first edge
- 103yz: second edge
- 103zx: third edge
- 11x: transverse measuring element
- 11y: longitudinal measuring element
- 11z: vertical measuring element
- 111x: transverse post
- 111y: longitudinal post
- 111z: vertical post
- 111yz: transverse post surface
- 111zx: longitudinal post surface
- 111xy: vertical post surface
- 112x: transverse seismic mass
- 112y: longitudinal seismic mass
- 112z: vertical seismic mass
- 113x: transverse piezoelectric element
- 113y: longitudinal piezoelectric element
- 113z: vertical piezoelectric element
- 113x+: transverse face
- 113x-: ground transverse face
- 113y+: longitudinal face
- 113y-: ground longitudinal face
- 113z+: vertical face
- 113z-: ground vertical face
- 114x: transverse preloading element
- 114y: longitudinal preloading element
- 114z: vertical preloading element
- 115x: transverse measuring element wire
- 115y: longitudinal measuring element wire
- 115z: vertical measuring element wire
- 116g: ground housing wire
- 12: flexible printed circuit board element
- 12c: connector section
- 12d: circuit board substrate surface
- 12d': flexible substrate surface
- 12f, 12f', 12f'': flexible section
- 12s: circuit board substrate
- 12s': flexible substrate
- 12x: transverse circuit board section
- 12y: longitudinal circuit board section
- 12z: vertical circuit board section
- 121g: ground connector
- 121x: transverse connection site
- 121y: longitudinal connection site
- 121z: vertical connection site
- 122x: transverse IEPE
- 122y: longitudinal IEPE
- 122z: vertical IEPE
- 123x: transverse TEDS
- 123y: longitudinal TEDS
- 123z: vertical TEDS
- 124g: ground connection area
- 124x: transverse connection area
- 124y: longitudinal connection area
- 124z: vertical connection area
- 125x: transverse electrostatic discharge protector
- 125y: longitudinal electrostatic discharge protector
- 125z: vertical electrostatic discharge protector
- 127g: ground electric conductor
- 127x: transverse electric conductor
- 127y: longitudinal electric conductor
- 127z: vertical electric conductor
- 128: underside
- 13x, 13z: cover element
- 14: connector element
- 140: connector housing element
- 140': connector housing through hole
- 141g: ground electric connector conductor
- 141x: transverse electric connector conductor
- 141y: longitudinal electric connector conductor
- 141z: vertical electric connector conductor
- 142: electric insulation element
- Cx: transverse electric charge
- Cy: longitudinal electric charge
- Cz: vertical electric charge
- EC: electrical connection
- EGC: electrical ground connection
- FEC: further electrical connection
- Ix: transverse Information
- Iy: longitudinal information
- Iz: vertical information
- NE: number of first electrical connections
- NFE: number of further electrical connections
- Ug: ground output voltage
- Ux: transverse output voltage
- Uy: longitudinal output voltage
- Uz: vertical output voltage
- x: transverse axis
- y: longitudinal axis
- z: vertical axis

## Claims

1. A method of manufacturing a piezoelectric acceleration sensor (1), which piezoelectric acceleration sensor (1) comprises a housing element (10), a plurality of measuring elements (11x, 11y, 11z), a flexible printed circuit board element (12) and a connector element (14), which housing element (10) comprises an inner space (101) and a body element (103) in the inner space (101), which plurality of measuring elements (11x, 11y, 11z) measures an acceleration along a plurality of sensitive axes (x, y, z) and creates a plurality of electric charges (Cx, Cx, Cy) for the measured acceleration, which flexible printed circuit board element (12) hosts a plurality of IEPE (122x, 122y, 122z), each of the plurality of IEPE (122x, 122y, 122z) amplifies and converts electric charge (Cx, Cy, Cz) from a related one of the plurality of measuring elements (11x, 11y, 11z) into an output voltage (Ux, Uy, Uz), which flexible printed circuit board element (12) establishes a ground output voltage (Ug); the method comprising
a step I
of introducing the flexible printed circuit board element (12) in the inner space (101) of the housing element (10) and of mechanically fixing the flexible printed circuit board element (12) to the body element (103);
a step II
of introducing the plurality of measuring elements (11x, 11y, 11z) in the inner space (101) of the housing element (10) and of mechanically fixing the plurality of measuring elements (11x, 11y, 11z) to the body element (103);
a step III
of realizing first electrical connections (EC) of each of the plurality of measuring elements (11x, 11y, 11z) with a related one of a plurality of circuit board sections (12x, 12y, 12z) of the flexible printed circuit board element (12), the number of first electrical connections (NE) is equal to the number of the plurality of sensitive axes (x, y, z); and
a step IV
of realizing further electrical connections (FEC) of the connector element (14) with a connector section (12c) of the flexible printed circuit board element (12), the number of further electrical connections (NFE) is equal to the number of the plurality of output voltages (Ux, Uy, Uz, Ug), and
of mounting the electrically connected connector element (14) on the housing element (10).

2. The method according to claim 1, wherein the body element (103) has a plurality of surfaces (103x 103y, 103z), including a transverse surface (103x) which is oriented normal to a transverse axis (x), a longitudinal surface (103y) which is oriented normal to a longitudinal axis (y) and a vertical surface (103z) which is oriented normal to a vertical axis (z), the transverse axis (x), longitudinal axis (y) and vertical axis (z) are perpendicular to each other,
wherein the plurality of circuit board sections (12x, 12y, 12z) include a transverse circuit board section (12x), a longitudinal circuit board section (12y) and a vertical circuit board section (12z),
wherein the plurality of measuring elements (11x, 11y, 11z) includes a transverse measuring element (11x) which measures an acceleration along the transverse axis (x) as sensitive axis (x), a longitudinal measuring element (11y) which measures an acceleration along the longitudinal axis (y) as sensitive axis (y) and a vertical measuring element (11z) which measures an acceleration along the vertical axis (z) as sensitive axis (z),
wherein in step I the transverse circuit board section (12x) is mechanically fixed to the transverse surface (103x), the longitudinal circuit board section (12y) is mechanically fixed to the longitudinal surface (103y) and a vertical circuit board section (12z) is mechanically fixed to the vertical surface (103z).

3. The method according to claim 2, wherein in step II the transverse measuring element (11x) is mechanically fixed to the transverse surface (103x), the longitudinal measuring element (11y) is mechanically fixed to the longitudinal surface (103y) and the vertical measuring element (11z) is mechanically fixed to the vertical surface (103z).

4. The method according to any of the claims 1 to 3, wherein two of the plurality of surfaces (103x 103y, 103z) are directly adjacent and are separated from each other by a common edge (103xy, 103yz, 103zx), including a first edge (103xy) which separates the transverse surface (103x) from the longitudinal surface (103y) and a second edge (103yz) which separates the longitudinal surface (103y) from the vertical surface (103z),
wherein the flexible printed circuit board element (12) comprises a connector section (12c) and a plurality of flexible sections (12f, 12f', 12f''), including a first flexible section (12f) which flexibly links the transverse circuit board section (12x) with the vertical circuit board section (12z), a second flexible section (12f') which flexibly links the longitudinal circuit board section (12y) with the vertical circuit board section (12z) and a third flexible section (12f'') which flexibly links the vertical circuit board section (12z) with the connector section (12c),
wherein in step I the first flexible section (12f) is bent and crosses the first edge (103xy) and the second flexible section (12f') is bent and crosses the second edge (103yz).

5. The method according to claim 4, wherein the housing element (10) comprises a plurality of housing openings (102x, 102y, 102z), including a transverse housing opening (102x) to access the inner space (101) from the direction of the transverse axis (x), a longitudinal housing opening (102y) to access the inner space (101) from the direction of the longitudinal axis (y) and a vertical housing opening (102z) to access the inner space (101) from the direction of the vertical axis (z),
wherein in step I the third flexible section (12f'') is bent and the connector section (12c) reaches through the vertical housing opening (102z) towards the outside of the housing element (10); and
wherein in step II the transverse measuring element (11x) is introduced via the transverse housing opening (102x) in the inner space (101), the longitudinal measuring element (11y) is introduced via the longitudinal housing opening (102y) in the inner space (101) and the vertical measuring element (11z) is introduced via the vertical housing opening (102z) in the inner space (101).

6. The method according to any of the claims 2 to 5, wherein in step I a fixation means (15) is provided and the fixation means (15) is applied on the plurality of surfaces (103x, 103y, 103z) of the body element (103) prior to the introduction of the flexible printed circuit board element (12) in the inner space (101) of the housing element (10); and
wherein each of the plurality of circuit board sections (12x, 12y, 12z) comprises an underside (128) and in step I the underside (128) of the transverse circuit board section (12x) is mechanically contacted with the applied fixation means (15) and mechanically fixed by adhesive bonding via the applied fixation means (15) to the transverse surface (103x), the underside (128) of the longitudinal circuit board section (12y) is mechanically contacted with the applied fixation means (15) and mechanically fixed by adhesive bonding via the applied fixation means (15) to the longitudinal surface (103y) and the underside (128) of the vertical circuit board section (12z) is mechanically contacted with the applied fixation means (15) and mechanically fixed by adhesive bonding via the applied fixation means (15) to the vertical surface (103z).

7. The method according to any of the claims 2 to 6, wherein each of the plurality of measuring elements (11x, 11y, 11z) comprises a post (111x, 111y, 111z), a seismic mass (112x, 112y, 112z) and a piezoelectric element (113x, 113, 113z), the plurality of posts (111x, 111y, 111z) comprises a transverse post (111x) which mechanically supports a transverse seismic mass (112x) and a transverse piezoelectric element (113x) of the transverse measuring element (11x) and comprises a transverse post surface (111yz), a longitudinal post (111y) which mechanically supports a longitudinal seismic mass (112y) and a longitudinal piezoelectric element (113y) of the longitudinal measuring element (11y) and comprises a longitudinal post surface (111zx) and a vertical post (111z) which mechanically supports a vertical seismic mass (112z) and a vertical piezoelectric element (113z) of the vertical measuring element (11z) and comprises a vertical post surface (111xy),
wherein in step II the transverse post surface (111yz) of the transverse measuring element (11x) is mechanically fixed by material bonding to the transverse surface (103x), the longitudinal post surface (111zx) of the longitudinal measuring element (11y) is mechanically fixed by material bonding to the longitudinal surface (103y) and the vertical post surface (111xy) of the vertical measuring element (11z) is mechanically fixed by material bonding to the vertical surface (103z).

8. The method according to any of the claims 2 to 7, wherein each of the plurality of circuit board sections (12x, 12y, 12z) comprises a connection site (121x, 121y, 121z), including a transverse connection site (121x), a longitudinal connection site (121y) and a vertical connection site (121z),
wherein a plurality of measuring element wires (115x, 115y, 115z) is provided, including a transverse measuring element wire (115x), a longitudinal measuring element wire (115y) and a vertical measuring element wire (115z),
wherein in step III the first electrical connection (EC) of the transverse measuring element (11x) to a transverse connection site (121x), is realized by a transverse measuring element wire (115x), the first electrical connection (EC) of the longitudinal measuring element (11y) to the longitudinal connection site (121y) is realized by a longitudinal measuring element wire (115y) and the first electrical connection (EC) of the vertical measuring element (11z) to the vertical connection site (121z) is realized by a vertical measuring element wire (115z).

9. The method according to any of the claims 7 or 8, wherein the plurality of piezoelectric elements (113x, 113y, 113z) comprise a plurality of ground faces (113x-, 113y-, 113z-), including a second transverse face (113x-), where ground electric charge (Cg) is created for an acceleration, the ground transverse face (113x-) is electrically connected with the transverse post (111x), a ground longitudinal face (113y-), where ground electric charge (Cg) is created for an acceleration, the ground longitudinal face (113y-) is electrically connected with the longitudinal post (111y) and a ground vertical face (113z-), where ground electric charge (Cg) is created for an acceleration, the ground vertical face (113z-) is electrically connected with the vertical post (111z),
wherein in step II the mechanic fixation of the transverse measuring element (11x) to the transverse surface (103x) electrically connects the transverse post (111x) with the transverse surface (103x), the mechanic fixation of the longitudinal measuring element (11y) to the longitudinal surface (103y) electrically connects the longitudinal post (111y) with the longitudinal surface (103y), and the mechanic fixation of the vertical measuring element (11z) to the vertical surface (103z) electrically connects the vertical post (111z) with the vertical surface (103x).

10. The method according to claim 8, wherein each of the plurality of circuit board sections (12x, 12y, 12z) comprises an IEPE (122x, 122y, 122z), including a transverse IEPE (122x) on the transverse circuit board section (12x), the transverse connection site (121x) is electrically connected to an IEPE input of the transverse IEPE (122x), a longitudinal IEPE (122y) on the longitudinal circuit board section (12y) which amplifies and converts longitudinal electric charge (Cy) from the longitudinal measuring element (11y) into a longitudinal output voltage (Uy), the longitudinal connection site (121y) is electrically connected to an IEPE input of the longitudinal IEPE (122y) and a vertical IEPE (122z) on the circuit board section (12z) which amplifies and converts vertical electric charge (Cz) from the vertical measuring element (11z) into a vertical output voltage (Uz), the vertical connection site (121z) is electrically connected to an IEPE input of the vertical IEPE (122z),
wherein in step III the first electrical connection of the transverse measuring element (11x) to the transverse connection site (121x) electrically conducts transverse electric charge (Cx) from the transverse measuring element (11x) to the transverse IEPE (122x) which amplifies and converts the transverse electric charge (Cx) into a transverse output voltage (Ux), the first electrical connection of the longitudinal measuring element (11y) to the longitudinal connection site (121y) electrically conducts longitudinal electric charge (Cy) from the longitudinal measuring element (11y) to the longitudinal IEPE (122y) which amplifies and converts the longitudinal electric charge (Cy) into a longitudinal output voltage (Uy), and the first electrical connection of the vertical measuring element (11z) to the vertical connection site (121z) electrically conducts vertical electric charge (Cz) from the vertical measuring element (11z) to the vertical IEPE (122z) which amplifies and converts the vertical electric charge (Cz) into a vertical output voltage (Uz).

11. The method according to any of the claims 2 to 10, wherein the connector element (14) comprises a plurality of electric connector conductors (141x, 141y, 141z, 141g), including a transversal electric connector conductor (141x), a longitudinal electric connector conductor (141y), a vertical electric connector conductor (141z) and a ground electric connector conductor (141g),
wherein the connector section (12c) comprises a plurality of connection areas (124x, 124y, 124z, 124g), including a transverse connection area (124x), a longitudinal connection area (124y), a vertical connection area (124z) and a ground connection area (124g),
wherein in step IV the further electrical connection (FEC) is realized between the transverse electric connector conductor (141x) and the transverse connection area (124x), the further electrical connection (FEC) is realized between the longitudinal electric connector conductor (141y) and the longitudinal connection area (124y), the further electrical connection (FEC) is realized between the vertical electric connector conductor (141z) and the vertical connection area (124z) and the further electrical connection (FEC) is realized between the ground electric connector conductor (141g) and the ground connection area (124g).

12. The method according to claim 11, wherein the connector element )14) comprises a connector housing element (140) and in step IV, a ground housing wire (116g) is provided and an electrical ground connection (EGC) is realized by electrically connecting the connector housing element (140) by means of the ground housing wire (116g) with the ground electric connector conductor (141g).

13. A piezoelectric acceleration sensor (1) comprising a housing element (10) with a body element (103), a plurality of measuring elements (11x, 11y, 11z), a flexible printed circuit board element (12) and a connector element (14), which housing element (10) comprises an inner space (101) and a body element (103) in the inner space (101), which plurality of measuring elements (11x, 11y, 11z) measures an acceleration along a plurality of sensitive axes (x, y, z) and creates a plurality of electric charges (Cx, Cx, Cy) for the measured acceleration, which plurality of measuring elements (11x, 11y, 11z) is mechanically fixed to the body element (103), which flexible printed circuit board element (12) hosts a plurality of IEPE (122x, 122y, 122z), each of the plurality of IEPE (122x, 122y, 122z) amplifies and converts electric charge (Cx, Cy, Cz) from a related one of the plurality of measuring elements (11x, 11y, 11z) into an output voltage (Ux, Uy, Uz), which flexible printed circuit board element (12) establishes a ground output voltage (Ug), which flexible printed circuit board element (12) is mechanically fixed to the body element (103);
wherein the flexible printed circuit board element (12) comprises a plurality of circuit board sections (12x, 12y, 12z), each of the circuit board sections (12x, 12y, 12z) hosts one the plurality of IEPE (122x, 122y, 122z), each of the plurality of measuring elements (11x, 11y, 11z) has a first electrical connection (EC) with a related one of the plurality of circuit board sections (12x, 12y, 12z), the number of first electrical connections (NE) is equal to the number of the plurality of sensitive axes (x, y, z);
wherein the flexible printed circuit board element (12) comprises a connector section (12c) and the connector element (14) has a further electrical connection (FEC) with the connector section (12c), the number of further electrical connections (NFE) is equal to the number of the plurality of output voltages (Ux, Uy, Uz, Ug).

14. The piezoelectric acceleration sensor (1) according to claim 13, wherein the plurality of measuring elements (11x, 11y, 11z) includes a transverse measuring element (11x) which measures an acceleration along the transverse axis (x) as sensitive axis (x), a longitudinal measuring element (11y) which measures an acceleration along the longitudinal axis (y) as sensitive axis (y) and a vertical measuring element (11z) which measures an acceleration along the vertical axis (z) as sensitive axis (z);
wherein each of the plurality of circuit board sections (12x, 12y, 12z) comprises a connection site (121x, 121y, 121z), including a transverse connection site (121x), a longitudinal connection site (121y) and a vertical connection site (121z); and
wherein the first electrical connection (EC) of the transverse measuring element (11x) to a transverse connection site (121x), is realized by a transverse measuring element wire (115x), the first electrical connection (EC) of the longitudinal measuring element (11y) to the longitudinal connection site (121y) is realized by a longitudinal measuring element wire (115y) and the first electrical connection (EC) of the vertical measuring element (11z) to the vertical connection site (121z) is realized by a vertical measuring element wire (115z).

15. The piezoelectric acceleration sensor (1) according to any of the claims 13 or 14, wherein the connector element (14) comprises a plurality of electric connector conductors (141x, 141y, 141z, 141g), including a transversal electric connector conductor (141x), a longitudinal electric connector conductor (141y), a vertical electric connector conductor (141z) and a ground electric connector conductor (141g),
wherein the connector section (12c) comprises a plurality of connection areas (124x, 124y, 124z, 124g), including a transverse connection area (124x), a longitudinal connection area (124y), a vertical connection area (124z) and a ground connection area (124g),
wherein the further electrical connection (FEC) is realized between the transverse electric connector conductor (141x) and the transverse connection area (124x), the further electrical connection (FEC) is realized between the longitudinal electric connector conductor (141y) and the longitudinal connection area (124y), the further electrical connection (FEC) is realized between the vertical electric connector conductor (141z) and the vertical connection area (124z) and the further electrical connection (FEC) is realized between the ground electric connector conductor (141g) and the ground connection area (124g).

16. The piezoelectric acceleration sensor (1) according to any of the claims 13 to 15, wherein the connector element )14) comprises a connector housing element (140) and the electrical connection of the connector housing element (140) by means of a ground housing wire (116g) with the ground electric connector conductor (141g) realizes an electrical ground connection (EGC).

17. The piezoelectric acceleration sensor (1) according to any of the claims 13 to 16, wherein the plurality of IEPS (122x, 122y, 122z) includes a transverse IEPE (122x) which amplifies and converts transverse electric charge (Cx) from a transverse measuring element (11x) into a transverse output voltage (Ux), a longitudinal IEPE (122y) which amplifies and converts longitudinal electric charge (Cy) from a longitudinal measuring element (11y) into a longitudinal output voltage (Uy), and a vertical IEPE (122z) which amplifies and converts vertical electric charge (Cz) from a vertical measuring element (11x) into a vertical output voltage (Uz);
wherein the connector element (14) comprises a plurality of electric connector conductors (141x, 141y, 141z, 141g), including a transversal electric connector conductor (141x), a longitudinal electric connector conductor (141y), a vertical electric connector conductor (141z) and a ground electric connector conductor (141g);
wherein the connector section (12c) comprises a plurality of connection areas (124x, 124y, 124z, 124g), including a transverse connection area (124x), a longitudinal connection area (124y), a vertical connection area (124z) and a ground connection area (124g);
wherein the further electrical connection (FEC) is realized between the transverse electric connector conductor (141x) and the transverse connection area (124x), the further electrical connection (FEC) is realized between the longitudinal electric connector conductor (141y) and the longitudinal connection area (124y), the further electrical connection (FEC) is realized between the vertical electric connector conductor (141z) and the vertical connection area (124z) and the further electrical connection is realized between the ground electric connector conductor (141g) and the ground connection area (124g); and
wherein the transverse electric connector conductor (141x) electrically conducts the transverse output voltage (Ux), the longitudinal electric connector conductor (141y) electrically conducts the longitudinal output voltage (Uy), the vertical electric connector conductor (141z) electrically conducts the vertical output voltage (Uz) and the ground electric connector conductor (141g) electrically conducts the ground output voltage (Ug).

18. The piezoelectric acceleration sensor (1) according to claim 15, wherein the flexible printed circuit board element (12) hosts a plurality of TEDS (123x, 123y, 123z), the plurality of TEDS (123x, 123y, 123z) includes a transverse TEDS (123x) which stores transverse information (Ix) about a related transverse measuring element (11x), a longitudinal TEDS (123y) which stores longitudinal information (Iy) about a related longitudinal measuring element (11y) and a vertical TEDS (123z) which stores vertical information (Iz) about a related vertical measuring element (11z); and
wherein the transverse electric connector conductor (141x) electrically conducts the transverse information (Ix), the longitudinal electric connector conductor (141y) electrically conducts the longitudinal information (Iy), and the vertical electric connector conductor (141z) electrically conducts the vertical information (Iz).

## Patentansprüche

1. Verfahren zur Herstellung eines piezoelektrischen Beschleunigungssensors (1), wobei der piezoelektrische Beschleunigungssensor (1) ein Gehäuseelement (10), eine Mehrzahl von Messelementen (11x, 11y, 11z), ein flexibles Leiterplattenelement (12) und ein Verbindungselement (14) umfasst, wobei das Gehäuseelement (10) einen Innenraum (101) und ein Körperelement (103) im Innenraum (101) aufweist, wobei die Mehrzahl von Messelementen (11x, 11y, 11z) eine Beschleunigung entlang einer Mehrzahl empfindlicher Achsen (x, y, z) misst und eine Mehrzahl elektrischer Ladungen (Cx, Cy, Cz) für die gemessene Beschleunigung erzeugt, wobei das flexible Leiterplattenelement (12) eine Mehrzahl von IEPE (122x, 122y, 122z) beherbergt, wobei jeder der Mehrzahl von IEPE (122x, 122y, 122z) elektrische Ladung (Cx, Cy, Cz) von einem zugehörigen der Mehrzahl von Messelementen (11x, 11y, 11z) verstärkt und in eine Ausgangsspannung (Ux, Uy, Uz) umwandelt, wobei das flexible Leiterplattenelement (12) eine Masse-Ausgangsspannung (Ug) festlegt; wobei das Verfahren Folgendes umfasst:
einen Schritt I,
in dem das flexible Leiterplattenelement (12) in den Innenraum (101) des Gehäuseelements (10) eingebracht wird und das flexible Leiterplattenelement (12) am Körperelement (103) mechanisch befestigt wird;
einen Schritt II,
in dem die Mehrzahl von Messelementen (11x, 11y, 11z) in den Innenraum (101) des Gehäuseelements (10) eingebracht wird und die Mehrzahl von Messelementen (11x, 11y, 11z) am Körperelement (103) mechanisch befestigt wird;
einen Schritt III
der Realisierung erster elektrischer Verbindungen (EC) von jedem der Mehrzahl von Messelementen (11x, 11y, 11z) mit einem zugehörigen aus einer Mehrzahl von Leiterplattenabschnitten (12x, 12y, 12z) des flexiblen Leiterplattenelements (12), wobei die Anzahl der ersten elektrischen Verbindungen (NE) der Anzahl der mehreren empfindlichen Achsen (x, y, z) entspricht; und
einen Schritt IV
der Realisierung weiterer elektrischer Verbindungen (FEC) von dem Verbindungselement (14) mit einem Verbindungsabschnitt (12c) des flexiblen Leiterplattenelements (12), wobei die Anzahl der weiteren elektrischen Verbindungen (NFE) gleich der Anzahl der Mehrzahl von Ausgangsspannungen (Ux, Uy, Uz, Ug) entspricht, und der Montage des elektrisch verbundenen Verbindungselements (14) am Gehäuseelement (10).

2. Verfahren nach Anspruch 1, wobei das Körperelement (103) eine Mehrzahl von Flächen (103x, 103y, 103z) aufweist, einschließlich einer transversalen Fläche (103x), die senkrecht zu einer Transversalachse (x) ausgerichtet ist, einer longitudinalen Fläche (103y), die senkrecht zu einer Längsachse (y) ausgerichtet ist, und einer vertikalen Fläche (103z), die senkrecht zu einer Vertikalachse (z) ausgerichtet ist, wobei die Transversalachse (x), die Längsachse (y) und die Vertikalachse (z) senkrecht zueinander stehen,
wobei die Mehrzahl von Leiterplattenabschnitten (12x, 12y, 12z) einen transversalen Leiterplattenabschnitt (12x), einen longitudinalen Leiterplattenabschnitt (12y) und einen vertikalen Leiterplattenabschnitt (12z) umfasst,
wobei die Mehrzahl von Messelementen (11x, 11y, 11z) ein transversales Messelement (11x), das eine Beschleunigung entlang der Transversalachse (x) als empfindliche Achse (x) misst, ein longitudinales Messelement (11y), das eine Beschleunigung entlang der Längsachse (y) als empfindliche Achse (y) misst, und ein vertikales Messelement (11z), das eine Beschleunigung entlang der Vertikalachse (z) als empfindliche Achse (z) misst, umfasst,
wobei in Schritt I der transversale Leiterplattenabschnitt (12x) mechanisch an der transversalen Fläche (103x) befestigt wird, der longitudinale Leiterplattenabschnitt (12y) mechanisch an der longitudinalen Fläche (103y) befestigt wird und ein vertikaler Leiterplattenabschnitt (12z) mechanisch an der vertikalen Fläche (103z) befestigt wird.

3. Verfahren nach Anspruch 2, wobei in Schritt II das transversale Messelement (11x) mechanisch an der transversalen Fläche (103x) befestigt wird, das longitudinale Messelement (11y) mechanisch an der longitudinalen Fläche (103y) befestigt wird und das vertikale Messelement (11z) mechanisch an der vertikalen Fläche (103z) befestigt wird.

4. Verfahren nach einem der Ansprüche 1 bis 3, wobei zwei der Mehrzahl von Flächen (103x, 103y, 103z) direkt aneinandergrenzen und durch eine gemeinsame Kante (103xy, 103yz, 103zx), einschließlich einer ersten Kante (103xy), welche die transversale Fläche (103x) von der longitudinalen Fläche (103y) trennt, und einer zweiten Kante (103yz), welche die longitudinale Fläche (103y) von der vertikalen Fläche (103z) trennt, voneinander getrennt sind,
wobei das flexible Leiterplattenelement (12) einen Verbindungsabschnitt (12c) und eine Mehrzahl flexibler Abschnitte (12f, 12f', 12f'') umfasst, einschließlich eines ersten flexiblen Abschnitts (12f), der den transversalen Leiterplattenabschnitt (12x) flexibel mit dem vertikalen Leiterplattenabschnitt (12z) verbindet, eines zweiten flexiblen Abschnitts (12f'), der den longitudinalen Leiterplattenabschnitt (12y) flexibel mit dem vertikalen Leiterplattenabschnitt (12z) verbindet, und eines dritten flexiblen Abschnitts (12f''), der den vertikalen Leiterplattenabschnitt (12z) flexibel mit dem Verbindungsabschnitt (12c) verbindet,
wobei in Schritt I der erste flexible Abschnitt (12f) gebogen wird und die erste Kante (103xy) überquert und der zweite flexible Abschnitt (12f') gebogen wird und die zweite Kante (103yz) überquert.

5. Verfahren nach Anspruch 4, wobei das Gehäuseelement (10) eine Mehrzahl von Gehäuseöffnungen (102x, 102y, 102z) umfasst, einschließlich einer transversalen Gehäuseöffnung (102x) für den Zugang zum Innenraum (101) aus der Richtung der Transversalachse (x), einer longitudinalen Gehäuseöffnung (102y) für den Zugang zum Innenraum (101) aus der Richtung der Längsachse (y) und einer vertikalen Gehäuseöffnung (102z) für den Zugang zum Innenraum (101) aus der Richtung der Vertikalachse (z),
wobei in Schritt I der dritte flexible Abschnitt (12f'') gebogen wird und der Verbindungsabschnitt (12c) durch die vertikale Gehäuseöffnung (102z) hindurch zur Außenseite des Gehäuseelements (10) ragt; und
wobei in Schritt II das transversale Messelement (11x) durch die transversale Gehäuseöffnung (102x) in den Innenraum (101) eingebracht wird, das longitudinale Messelement (11y) durch die longitudinale Gehäuseöffnung (102y) in den Innenraum (101) eingebracht wird und das vertikale Messelement (11z) durch die vertikale Gehäuseöffnung (102z) in den Innenraum (101) eingebracht wird.

6. Verfahren nach einem der Ansprüche 2 bis 5, wobei in Schritt I ein Befestigungsmittel (15) bereitgestellt wird und das Befestigungsmittel (15) vor dem Einbringen des flexiblen Leiterplattenelements (12) in den Innenraum (101) des Gehäuseelements (10) auf die Mehrzahl von Oberflächen (103x, 103y, 103z) des Körperelements (103) aufgebracht wird; und
wobei jeder der Mehrzahl von Leiterplattenabschnitten (12x, 12y, 12z) eine Unterseite (128) umfasst und in Schritt I die Unterseite (128) des transversalen Leiterplattenabschnitts (12x) mit dem aufgebrachten Befestigungsmittel (15) mechanisch in Kontakt gebracht und über das aufgebrachte Befestigungsmittel (15) durch Kleben mechanisch an der transversalen Fläche (103x) befestigt wird, die Unterseite (128) des longitudinalen Leiterplattenabschnitts (12y) mit dem aufgebrachten Befestigungsmittel (15) mechanisch in Kontakt gebracht und über das aufgebrachte Befestigungsmittel (15) durch Kleben mechanisch an der longitudinalen Fläche (103y) befestigt wird und die Unterseite (128) des vertikalen Leiterplattenabschnitts (12z) mit dem aufgebrachten Befestigungsmittel (15) mechanisch in Kontakt gebracht und über das aufgebrachte Befestigungsmittel (15) durch Kleben mechanisch an der vertikalen Fläche (103z) befestigt wird.

7. Verfahren nach einem der Ansprüche 2 bis 6, wobei jedes der Mehrzahl von Messelementen (11x, 11y, 11z) einen Stift (111x, 111y, 111z), eine seismische Masse (112x, 112y, 112z) und ein piezoelektrisches Element (113x, 113y, 113z) umfasst, wobei die Mehrzahl von Stiften (111x, 111y, 111z) einen transversalen Stift (111x), der eine transversale seismische Masse (112x) und ein transversales piezoelektrisches Element (113x) des transversalen Messelements (11x) mechanisch stützt und eine transversale Stiftoberfläche (111yz) aufweist, einen longitudinalen Stift (111y), der eine longitudinale seismische Masse (112y) und ein longitudinales piezoelektrisches Element (113y) des longitudinalen Messelements (11y) mechanisch stützt und eine longitudinale Stiftoberfläche (111zx) aufweist, sowie einen vertikalen Stift (111z), der eine vertikale seismische Masse (112z) und ein vertikales piezoelektrisches Element (113z) des vertikalen Messelements (11z) mechanisch stützt und eine vertikale Stiftoberfläche (111xy) aufweist, umfasst,
wobei in Schritt II die transversale Stiftoberfläche (111yz) des transversalen Messelements (11x) durch Stoffschluss mechanisch an der transversalen Fläche (103x) befestigt wird, die longitudinale Stiftoberfläche (111zx) des longitudinalen Messelements (11y) durch Stoffschluss mechanisch an der longitudinalen Fläche (103y) befestigt wird und die vertikale Stiftoberfläche (111xy) des vertikalen Messelements (11z) durch Stoffschluss mechanisch an der vertikalen Fläche (103z) befestigt wird.

8. Verfahren nach einem der Ansprüche 2 bis 7, wobei jeder der Mehrzahl von Leiterplattenabschnitten (12x, 12y, 12z) eine Verbindungsstelle (121x, 121y, 121z), einschließlich einer transversalen Verbindungsstelle (121x), einer longitudinalen Verbindungsstelle (121y) und einer vertikalen Verbindungsstelle (121z), aufweist,
wobei eine Mehrzahl von Messelementdrähten (115x, 115y, 115z), einschließlich eines transversalen Messelementdrahts (115x), eines longitudinalen Messelementdrahts (115y) und eines vertikalen Messelementdrahts (115z), bereitgestellt wird,
wobei in Schritt III die erste elektrische Verbindung (EC) des transversalen Messelements (11x) mit einer transversalen Verbindungsstelle (121x) durch einen transversalen Messelementdraht (115x) realisiert wird, die erste elektrische Verbindung (EC) des longitudinalen Messelements (11y) mit der longitudinalen Verbindungsstelle (121y) durch einen longitudinalen Messelementdraht (115y) realisiert wird und die erste elektrische Verbindung (EC) des vertikalen Messelements (11z) mit der vertikalen Verbindungsstelle (121z) durch einen vertikalen Messelementdraht (115z) realisiert wird.

9. Verfahren nach einem der Ansprüche 7 oder 8, wobei die Mehrzahl piezoelektrischer Elemente (113x, 113y, 113z) eine Mehrzahl von Masseflächen (113x-, 113y-, 113z-), einschließlich einer zweiten transversalen Massefläche (113x-), an der elektrische Masseladung (Cg) für eine Beschleunigung erzeugt wird, wobei die transversale Massefläche (113x-) elektrisch mit dem transversalen Stift (111x) verbunden ist, einer longitudinalen Massefläche (113y-), an der eine elektrische Masseladung (Cg) für eine Beschleunigung erzeugt wird und die elektrisch mit dem longitudinalen Stift (111y) verbunden ist, sowie einer vertikalen Massefläche (113z-), an der eine elektrische Masseladung (Cg) für eine Beschleunigung erzeugt wird und die elektrisch mit dem vertikalen Stift (111z) verbunden ist, umfasst,
wobei in Schritt II die mechanische Befestigung des transversalen Messelements (11x) an der transversalen Fläche (103x) den transversalen Stift (111x) elektrisch mit der transversalen Fläche (103x) verbindet, die mechanische Befestigung des longitudinalen Messelements (11y) an der longitudinalen Fläche (103y) den longitudinalen Stift (111y) elektrisch mit der longitudinalen Fläche (103y) verbindet und die mechanische Befestigung des vertikalen Messelements (11z) an der vertikalen Fläche (103z) den vertikalen Stift (111z) elektrisch mit der vertikalen Fläche (103x) verbindet.

10. Verfahren nach Anspruch 8, wobei jeder der Mehrzahl von Leiterplattenabschnitten (12x, 12y, 12z) ein IEPE (122x, 122y, 122z) umfasst, einschließlich eines transversalen IEPE (122x) auf dem transversalen Leiterplattenabschnitt (12x), wobei die transversale Verbindungsstelle (121x) elektrisch mit einem IEPE-Eingang des transversalen IEPE (122x) verbunden ist, eines longitudinalen IEPE (122y) auf dem longitudinalen Leiterplattenabschnitt (12y), welches longitudinale elektrische Ladung (Cy) von dem longitudinalen Messelement (11y) verstärkt und in eine longitudinale Ausgangsspannung (Uy) umwandelt, wobei die longitudinale Verbindungsstelle (121y) elektrisch mit einem IEPE-Eingang des longitudinalen IEPE (122y) verbunden ist, und eines vertikalen IEPE (122z) auf dem Leiterplattenabschnitt (12z), welches vertikale elektrische Ladung (Cz) von dem vertikalen Messelement (11z) verstärkt und in eine vertikale Ausgangsspannung (Uz) umwandelt, wobei die vertikale Verbindungsstelle (121z) elektrisch mit einem IEPE-Eingang des vertikalen IEPE (122z) verbunden ist,
wobei in Schritt III die erste elektrische Verbindung des transversalen Messelements (11x) mit der transversalen Verbindungsstelle (121x) transversale elektrische Ladung (Cx) von dem transversalen Messelement (11x) zum transversalen IEPE (122x) leitet, welches die transversale elektrische Ladung (Cx) verstärkt und in eine transversale Ausgangsspannung (Ux) umwandelt, die erste elektrische Verbindung des longitudinalen Messelements (11y) mit der longitudinalen Verbindungsstelle (121y) longitudinale elektrische Ladung (Cy) von dem longitudinale Messelement (11y) zum longitudinalen IEPE (122y) leitet, welches die longitudinale elektrische Ladung (Cy) verstärkt und in eine longitudinale Ausgangsspannung (Uy) umwandelt, und die erste elektrische Verbindung des vertikalen Messelements (11z) mit der vertikalen Verbindungsstelle (121z) vertikale elektrische Ladung (Cz) von dem vertikalen Messelement (11z) zum vertikalen IEPE (122z) leitet, welches die vertikale elektrische Ladung (Cz) verstärkt und in eine vertikale Ausgangsspannung (Uz) umwandelt.

11. Verfahren nach einem der Ansprüche 2 bis 10, wobei das Verbindungselement (14) eine Mehrzahl elektrischer Verbindungsleiter (141x, 141y, 141z, 141g), einschließlich eines transversalen elektrischen Verbindungsleiters (141x), eines longitudinalen elektrischen Verbindungsleiters (141y), eines vertikalen elektrischen Verbindungsleiters (141z) und eines elektrischen Masse-Verbindungsleiters (141g), umfasst,
wobei der Verbindungsabschnitt (12c) eine Mehrzahl von Verbindungsbereichen (124x, 124y, 124z, 124g), einschließlich eines transversalen Verbindungsbereichs (124x), eines longitudinalen Verbindungsbereichs (124y), eines vertikalen Verbindungsbereichs (124z) und eines Masse-Verbindungsbereichs (124g), umfasst,
wobei in Schritt IV die weitere elektrische Verbindung (FEC) zwischen dem transversalen elektrischen Verbindungsleiter (141x) und dem transversalen Verbindungsbereich (124x) hergestellt wird, die weitere elektrische Verbindung (FEC) zwischen dem longitudinalen elektrischen Verbindungsleiter (141y) und dem longitudinalen Verbindungsbereich (124y) hergestellt wird, die weitere elektrische Verbindung (FEC) zwischen dem vertikalen elektrischen Verbindungsleiter (141z) und dem vertikalen Verbindungsbereich (124z) hergestellt wird und die weitere elektrische Verbindung (FEC) zwischen dem Masse-Verbindungsleiter (141g) und dem Masse-Verbindungsbereich (124g) hergestellt wird.

12. Verfahren nach Anspruch 11, wobei das Verbindungselement (14) ein Verbindungsgehäuseelement (140) umfasst und in Schritt IV ein Masse-Gehäusedraht (116g) bereitgestellt wird und eine elektrische Masseverbindung (EGC) hergestellt wird, indem das Verbindungsgehäuseelement (140) mithilfe des Masse-Gehäusedrahts (116g) mit dem elektrischen Masse-Verbindungsleiter (141g) elektrisch verbunden wird.

13. Piezoelektrischer Beschleunigungssensor (1), umfassend ein Gehäuseelement (10) mit einem Körperelement (103), eine Mehrzahl von Messelementen (11x, 11y, 11z), ein flexibles Leiterplattenelement (12) und ein Verbindungselement (14), wobei das Gehäuseelement (10) einen Innenraum (101) und ein im Innenraum (101) befindliches Körperelement (103) umfasst, wobei die Mehrzahl von Messelementen (11x, 11y, 11z) eine Beschleunigung entlang einer Mehrzahl von empfindlichen Achsen (x, y, z) misst und eine Mehrzahl elektrischer Ladungen (Cx, Cy, Cz) für die gemessene Beschleunigung erzeugt, wobei die Mehrzahl von Messelementen (11x, 11y, 11z) am Körperelement (103) mechanisch befestigt ist, wobei das flexible Leiterplattenelement (12) eine Mehrzahl von IEPE (122x, 122y, 122z) beherbergt, wobei jedes der Mehrzahl von IEPE (122x, 122y, 122z) elektrische Ladung (Cx, Cy, Cz) von einem zugehörigen der Mehrzahl von Messelementen (11x, 11y, 11z) verstärkt und in eine Ausgangsspannung (Ux, Uy, Uz) umwandelt, wobei das flexible Leiterplattenelement (12) eine Masse-Ausgangsspannung (Ug) bereitstellt, wobei das flexible Leiterplattenelement (12) am Körperelement (103) mechanisch befestigt ist;
wobei das flexible Leiterplattenelement (12) eine Mehrzahl von Leiterplattenabschnitten (12x, 12y, 12z) umfasst, wobei jeder der Leiterplattenabschnitte (12x, 12y, 12z) eines der Mehrzahl von IEPE (122x, 122y, 122z) beherbergt, wobei jedes der Mehrzahl von Messelementen (11x, 11y, 11z) eine erste elektrische Verbindung (EC) mit einem zugehörigen der Mehrzahl von Leiterplattenabschnitten (12x, 12y, 12z) aufweist, wobei die Anzahl der ersten elektrischen Verbindungen (NE) gleich der Anzahl der Mehrzahl von empfindliche Achsen (x, y, z) ist;
wobei das flexible Leiterplattenelement (12) einen Verbindungsabschnitt (12c) umfasst und das Verbindungselement (14) eine weitere elektrische Verbindung (FEC) mit dem Verbindungsabschnitt (12c) aufweist, wobei die Anzahl an weiteren elektrischen Verbindungen (NFE) gleich der Anzahl der Mehrzahl von Ausgangsspannungen (Ux, Uy, Uz, Ug) ist.

14. Piezoelektrischer Beschleunigungssensor (1) nach Anspruch 13, wobei die Mehrzahl von Messelementen (11x, 11y, 11z) ein transversales Messelement (11x), das eine Beschleunigung entlang der Transversalachse (x) als empfindliche Achse (x) misst, ein longitudinales Messelement (11y), das eine Beschleunigung entlang der Längsachse (y) als empfindliche Achse (y) misst, und ein vertikales Messelement (11z), das eine Beschleunigung entlang der Vertikalachse (z) als empfindliche Achse (z) misst, umfasst;
wobei jeder der Mehrzahl von Leiterplattenabschnitten (12x, 12y, 12z) eine Verbindungsstelle (121x, 121y, 121z), einschließlich einer transversalen Verbindungsstelle (121x), einer longitudinalen Verbindungsstelle (121y) und einer vertikalen Verbindungsstelle (121z), umfasst; und
wobei die erste elektrische Verbindung (EC) des transversalen Messelements (11x) zu einer transversale Verbindungsstelle (121x) durch einen transversalen Messelementdraht (115x) realisiert wird, die erste elektrische Verbindung (EC) des longitudinalen Messelements (11y) zu der longitudinalen Verbindungsstelle (121y) durch einen longitudinalen Messelementdraht (115y) realisiert wird und die erste elektrische Verbindung (EC) des vertikalen Messelements (11z) zu der vertikalen Verbindungsstelle (121z) durch einen vertikalen Messelementdraht (115z) realisiert wird.

15. Piezoelektrischer Beschleunigungssensor (1) nach einem der Ansprüche 13 oder 14, wobei das Verbindungselement (14) eine Mehrzahl von elektrischen Verbindungsleitern (141x, 141y, 141z, 141g), einschließlich eines transversalen elektrischen Verbindungsleiters (141x), eines longitudinalen elektrischen Verbindungsleiters (141y), eines vertikalen elektrischen Verbindungsleiters (141z) und eines elektrischen Masse-Verbindungsleiters (141g), umfasst,
wobei der Verbindungsabschnitt (12c) eine Mehrzahl von Verbindungsbereichen (124x, 124y, 124z, 124g), einschließlich eines transversalen Verbindungsbereichs (124x), eines longitudinalen Verbindungsbereichs (124y), eines vertikalen Verbindungsbereichs (124z) und eines Masse-Verbindungsbereichs (124g), umfasst,
wobei die weitere elektrische Verbindung (FEC) zwischen dem transversalen elektrischen Verbindungsleiter (141x) und dem transversalen Verbindungsbereich (124x) realisiert wird, die weitere elektrische Verbindung (FEC) zwischen dem longitudinalen elektrischen Verbindungsleiter (141y) und dem longitudinalen Verbindungsbereich (124y) realisiert wird, die weitere elektrische Verbindung (FEC) zwischen dem vertikalen elektrischen Verbindungsleiter (141z) und dem vertikalen Verbindungsbereich (124z) realisiert wird und die weitere elektrische Verbindung (FEC) zwischen dem elektrischen Masse-Verbindungsleiter (141g) und dem Masse-Verbindungsbereich (124g) realisiert wird.

16. Piezoelektrischer Beschleunigungssensor (1) nach einem der Ansprüche 13 bis 15, wobei das Verbindungselement (14) ein Verbindungsgehäuseelement (140) umfasst und die elektrische Verbindung des Verbindungsgehäuseelements (140) mithilfe eines Gehäuse-Massedrahts (116g) mit dem elektrischen Masse-Verbindungsleiter (141g) eine elektrische Masseverbindung (EGC) herstellt.

17. Piezoelektrischer Beschleunigungssensor (1) nach einem der Ansprüche 13 bis 16, wobei die Mehrzahl von IEPE (122x, 122y, 122z) ein transversales IEPE (122x), welches transversale elektrische Ladung (Cx) von einem transversalen Messelement (11x) verstärkt und in eine transversale Ausgangsspannung (Ux) umwandelt; ein longitudinales IEPE (122y), welches longitudinale elektrische Ladung (Cy) von einem longitudinalen Messelement (11y) verstärkt und in eine longitudinale Ausgangsspannung (Uy) umwandelt; und ein vertikales IEPE (122z), welches vertikale elektrische Ladung (Cz) von einem vertikalen Messelement (11x) verstärkt und in eine vertikale Ausgangsspannung (Uz) umwandelt, umfasst;
wobei das Verbindungselement (14) eine Mehrzahl elektrischer Verbindungsleiter (141x, 141y, 141z, 141g), einschließlich eines transversalen elektrischen Verbindungsleiters (141x), eines longitudinalen elektrischen Verbindungsleiters (141y), eines vertikalen elektrischen Verbindungsleiters (141z) und eines elektrischen Masse-Verbindungsleiters (141g), umfasst;
wobei der Verbindungsabschnitt (12c) eine Mehrzahl von Verbindungsbereichen (124x, 124y, 124z, 124g), einschließlich eines transversalen Verbindungsbereichs (124x), eines longitudinalen Verbindungsbereichs (124y), eines vertikalen Verbindungsbereichs (124z) und eines Masse-Verbindungsbereichs (124g), umfasst;
wobei die weitere elektrische Verbindung (FEC) zwischen dem transversalen elektrischen Verbindungsleiter (141x) und dem transversalen Verbindungsbereich (124x) realisiert wird, die weitere elektrische Verbindung (FEC) zwischen dem longitudinalen elektrischen Verbindungsleiter (141y) und dem longitudinalen Verbindungsbereich (124y) realisiert wird, die weitere elektrische Verbindung (FEC) zwischen dem vertikalen elektrischen Verbindungsleiter (141z) und dem vertikalen Verbindungsbereich (124z) realisiert wird und die weitere elektrische Verbindung zwischen dem elektrischen Masse-Verbindungsleiter (141g) und dem Masse-Verbindungsbereich (124g) realisiert wird; und
wobei der transversale elektrische Verbindungsleiter (141x) die transversale Ausgangsspannung (Ux) elektrisch leitet, der longitudinale elektrische Verbindungsleiter (141y) die longitudinale Ausgangsspannung (Uy) elektrisch leitet, der vertikale elektrische Verbindungsleiter (141z) die vertikale Ausgangsspannung (Uz) elektrisch leitet und der elektrische Masse-Verbindungsleiter (141g) die Masse-Ausgangsspannung (Ug) elektrisch leitet.

18. Piezoelektrischer Beschleunigungssensor (1) nach Anspruch 15, wobei das flexible Leiterplattenelement (12) eine Mehrzahl von TEDS (123x, 123y, 123z) beherbergt, wobei die Mehrzahl von TEDS (123x, 123y, 123z) ein transversales TEDS (123x), das transversale Informationen (Ix) über ein zugehöriges transversales Messelement (11x) speichert, ein longitudinales TEDS (123y), das longitudinale Informationen (Iy) über ein zugehöriges longitudinales Messelement (11y) speichert, und ein vertikales TEDS (123z), das vertikale Informationen (Iz) über ein zugehöriges vertikales Messelement (11z) speichert, umfasst; und
wobei der transversale elektrische Verbindungsleiter (141x) die transversalen Informationen (Ix) elektrisch leitet, der longitudinale elektrische Verbindungsleiter (141y) die longitudinalen Informationen (Iy) elektrisch leitet und der vertikale elektrische Verbindungsleiter (141z) die vertikalen Informationen (Iz) elektrisch leitet.

## Revendications

1. Procédé de fabrication d'un capteur d'accélération piézoélectrique (1), lequel capteur d'accélération piézoélectrique (1) comprend un élément de boîtier (10), une pluralité d'éléments de mesure (11x, 11y, 11z), un élément de carte de circuit imprimé flexible (12) et un élément de connecteur (14), ledit élément de boîtier (10) comprenant un espace intérieur (101) et un élément de corps (103) situé dans l'espace intérieur (101), ladite pluralité d'éléments de mesure (11x, 11y, 11z) mesurant une accélération le long d'une pluralité d'axes sensitifs (x, y, z) et générant une pluralité de charges électriques (Cx, Cy, Cz) pour l'accélération mesurée, ledit élément de carte de circuit imprimé flexible (12) présentant une pluralité de circuits IEPE (122x, 122y, 122z), chacun de ladite pluralité de circuits IEPE (122x, 122y, 122z) amplifiant et convertissant la charge électrique (Cx, Cy, Cz) provenant d'un élément de mesure associé parmi la pluralité d'éléments de mesure (11x, 11y, 11z) en une tension de sortie (Ux, Uy, Uz), ledit élément de carte de circuit imprimé flexible (12) établissant une tension de sortie de masse (Ug); le procédé comprenant
une étape I
consistant à introduire l'élément de carte de circuit imprimé flexible (12) dans l'espace intérieur (101) de l'élément de boîtier (10) et à fixer mécaniquement l'élément de carte de circuit imprimé flexible (12) à l'élément de corps (103);
une étape II
consistant à introduire la pluralité d'éléments de mesure (11x, 11y, 11z) dans l'espace intérieur (101) de l'élément de boîtier (10) et à fixer mécaniquement la pluralité d'éléments de mesure (11x, 11y, 11z) à l'élément de corps (103);
une étape III
de réalisation de premières connexions électriques (EC) de chacun de la pluralité d'éléments de mesure (11x, 11y, 11z) avec une section associée parmi une pluralité de sections de carte de circuit (12x, 12y, 12z) de l'élément de carte de circuit imprimé flexible (12), le nombre de premières connexions électriques (NE) étant égal au nombre de la pluralité d'axes sensitifs (x, y, z); et
une étape IV
de réalisation de connexions électriques supplémentaires (FEC) de l'élément connecteur (14) avec une section de connecteur (12c) de l'élément de carte de circuit imprimé flexible (12), le nombre de connexions électriques supplémentaires (NFE) étant égal au nombre de la pluralité de tensions de sortie (Ux, Uy, Uz, Ug), et
de monter l'élément connecteur (14) électriquement connecté sur l'élément de boîtier (10).

2. Procédé selon la revendication 1, dans lequel l'élément de corps (103) présente une pluralité de surfaces (103x, 103y, 103z) incluant une surface transversale (103x) orientée perpendiculairement à un axe transversal (x), une surface longitudinale (103y) orientée perpendiculairement à un axe longitudinal (y) et une surface verticale (103z) orientée perpendiculairement à un axe vertical (z), l'axe transversal (x), l'axe longitudinal (y) et l'axe vertical (z) étant perpendiculaires entre eux,
a pluralité de sections de carte de circuit imprimé (12x, 12y, 12z) comprenant une section de carte de circuit imprimé transversale (12x), une section de carte de circuit imprimé longitudinale (12y) et une section de carte de circuit imprimé verticale (12z),
dans lequel la pluralité d'éléments de mesure (11x, 11y, 11z) comprend un élément de mesure transversal (11x) qui mesure une accélération le long de l'axe transversal (x) en tant qu'axe sensitif (x), un élément de mesure longitudinal (11y) qui mesure une accélération le long de l'axe longitudinal (y) en tant qu'axe sensitif (y) et un élément de mesure vertical (11z) qui mesure une accélération le long de l'axe vertical (z) en tant qu'axe sensitif (z),
dans lequel, à l'étape I, la section de carte de circuit imprimé transversale (12x) est fixée mécaniquement à la surface transversale (103x), la section de carte de circuit imprimé longitudinale (12y) est fixée mécaniquement à la surface longitudinale (103y) et une section de carte de circuit imprimé verticale (12z) est fixée mécaniquement à la surface verticale (103z).

3. Procédé selon la revendication 2, dans lequel, à l'étape II, l'élément de mesure transversal (11x) est fixé mécaniquement à la surface transversale (103x), l'élément de mesure longitudinal (11y) est fixé mécaniquement à la surface longitudinale (103y) et l'élément de mesure vertical (11z) est fixé mécaniquement à la surface verticale (103z).

4. Procédé selon l'une quelconque des revendications 1 à 3, dans lequel deux surfaces parmi la pluralité de surfaces (103x, 103y, 103z) sont directement adjacentes et séparées l'une de l'autre par un bord commun (103xy, 103yz, 103zx), incluant un premier bord (103xy) qui sépare la surface transversale (103x) de la surface longitudinale (103y) et un second bord (103yz) qui sépare la surface longitudinale (103y) de la surface verticale (103z),
dans lequel l'élément de carte de circuit imprimé flexible (12) comprend une section de connecteur (12c) et une pluralité de sections flexibles (12f, 12f', 12f") incluant une première section flexible (12f) qui relie de manière flexible la section de carte de circuit imprimé transversale (12x) à la section de carte de circuit imprimé verticale (12z), une seconde section flexible (12f') qui relie de manière flexible la section de carte de circuit imprimé longitudinale (12y) à la section de carte de circuit imprimé verticale (12z) et une troisième section flexible (12f") qui relie de manière flexible la section de carte de circuit imprimé verticale (12z) à la section de connecteur (12c), dans lequel, à l'étape I, la première section flexible (12f) est pliée et traverse le premier bord (103xy) et la seconde section flexible (12f') est pliée et traverse le second bord (103yz).

5. Procédé selon la revendication 4, dans lequel l'élément de boîtier (10) comprend une pluralité d'ouvertures de boîtier (102x, 102y, 102z) incluant une ouverture de boîtier transversale (102x) pour accéder à l'espace intérieur (101) depuis la direction de l'axe transversal (x), une ouverture de boîtier longitudinale (102y) pour accéder à l'espace intérieur (101) depuis la direction de l'axe longitudinal (y) et une ouverture de boîtier verticale (102z) pour accéder à l'espace intérieur (101) depuis la direction de l'axe vertical (z),
dans lequel, à l'étape I, la troisième section flexible (12f'') est pliée et la section de connecteur (12c) s'étend à travers l'ouverture de boîtier verticale (102z) vers l'extérieur de l'élément de boîtier (10); et
dans lequel, à l'étape II, l'élément de mesure transversal (11x) est introduit dans l'espace intérieur (101) par l'ouverture de boîtier transversale (102x), l'élément de mesure longitudinal (11y) est introduit dans l'espace intérieur (101) par l'ouverture de boîtier longitudinale (102y) et l'élément de mesure vertical (11z) est introduit dans l'espace intérieur (101) par l'ouverture de boîtier verticale (102z).

6. Procédé selon l'une quelconque des revendications 2 à 5, dans lequel, à l'étape I, un moyen de fixation (15) est prévu et le moyen de fixation (15) est appliqué à la pluralité de surfaces (103x, 103y, 103z) de l'élément de corps (103) avant l'introduction de l'élément de carte de circuit imprimé flexible (12) dans l'espace intérieur (101) de l'élément de boîtier (10) ; et
dans lequel chacune de la pluralité de sections de carte de circuit (12x, 12y, 12z) comprend une face inférieure (128) et, à l'étape I, la face inférieure (128) de la section de carte de circuit transversale (12x) est mise en contact mécanique avec le moyen de fixation (15) appliqué et est fixée mécaniquement par collage à la surface transversale (103x) par l'intermédiaire du moyen de fixation (15) appliqué, la face inférieure (128) de la section de carte de circuit longitudinale (12y) est mise en contact mécanique avec le moyen de fixation (15) appliqué et est fixée mécaniquement par collage à la surface longitudinale (103y) par l'intermédiaire du moyen de fixation (15) appliqué et la face inférieure (128) de la section de carte de circuit verticale (12z) est mise en contact mécanique avec le moyen de fixation (15) appliqué et est fixée mécaniquement par collage à la surface verticale (103z) par l'intermédiaire du moyen de fixation (15) appliqué.

7. Procédé selon l'une quelconque des revendications 2 à 6, dans lequel chacun de la pluralité d'éléments de mesure (11x, 11y, 11z) comprend une tige (111x, 111y, 111z), une masse sismique (112x, 112y, 112z) et un élément piézoélectrique (113x, 113y, 113z), la pluralité de tiges (111x, 111y, 111z) comprenant une tige transversale (111x) qui supporte mécaniquement une masse sismique transversale (112x) et un élément piézoélectrique transversal (113x) de l'élément de mesure transversal (11x) et comprend une surface de tige transversale (111yz), une tige longitudinale (111y) qui supporte mécaniquement une masse sismique longitudinale (112y) et un élément piézoélectrique longitudinal (113y) de l'élément de mesure longitudinal (11y) et comprend une surface de tige longitudinale (111zx), et une tige verticale (111z) qui supporte mécaniquement une masse sismique verticale (112z) et un élément piézoélectrique vertical (113z) de l'élément de mesure vertical (11z) et comprend une surface de tige verticale (111xy),
dans lequel, à l'étape II, la surface de tige transversale (111yz) de l'élément de mesure transversal (11x) est fixée mécaniquement par liaison de matières à la surface transversale (103x), la surface de tige longitudinale (111zx) de l'élément de mesure longitudinal (11y) est fixée mécaniquement par liaison de matières à la surface longitudinale (103y) et la surface de tige verticale (111xy) de l'élément de mesure vertical (11z) est fixée mécaniquement par liaison de matières à la surface verticale (103z).

8. Procédé selon l'une quelconque des revendications 2 à 7, dans lequel chacune de la pluralité de sections de carte de circuit imprimé (12x, 12y, 12z) comprend un site de connexion (121x, 121y, 121z) incluant un site de connexion transversal (121x), un site de connexion longitudinal (121y) et un site de connexion vertical (121z),
dans lequel une pluralité de fils d'élément de mesure (115x, 115y, 115z) est prévue incluant un fil d'élément de mesure transversal (115x), un fil d'élément de mesure longitudinal (115y) et un fil d'élément de mesure vertical (115z),
dans lequel, à l'étape III, la première connexion électrique (EC) de l'élément de mesure transversal (11x) à un site de connexion transversal (121x) est réalisée par un fil d'élément de mesure transversal (115x), la première connexion électrique (EC) de l'élément de mesure longitudinal (11y) au site de connexion longitudinal (121y) est réalisée par un fil d'élément de mesure longitudinal (115y) et la première connexion électrique (EC) de l'élément de mesure vertical (11z) au site de connexion vertical (121z) est réalisée par un fil d'élément de mesure vertical (115z).

9. Procédé selon l'une quelconque des revendications 7 ou 8, dans lequel la pluralité d'éléments piézoélectriques (113x, 113y, 113z) comprend une pluralité de faces de masse (113x-, 113y-, 113z-) incluant une seconde face transversale (113x-) où de la charge électrique de masse (Cg) est créée lors d'une accélération, ladite face transversale de masse (113x-) étant connectée électriquement à la tige transversale (111x), une face longitudinale de masse (113y-) où de la charge électrique de masse (Cg) est créée lors d'une accélération, ladite face longitudinale de masse (113y-) étant connectée électriquement à la tige longitudinale (111y), et une face verticale de masse (113z-) où de la charge électrique de masse (Cg) est créée lors d'une accélération, ladite face verticale de masse (113z-) étant connectée électriquement à la tige verticale (111z),
dans lequel, à l'étape II, la fixation mécanique de l'élément de mesure transversal (11x) à la surface transversale (103x) connecte électriquement la tige transversale (111x) à la surface transversale (103x), la fixation mécanique de l'élément de mesure longitudinal (11y) à la surface longitudinale (103y) connecte électriquement la tige longitudinale (111y) à la surface longitudinale (103y), et la fixation mécanique de l'élément de mesure vertical (11z) à la surface verticale (103z) connecte électriquement la tige verticale (111z) à la surface verticale (103x).

10. Procédé selon la revendication 8, dans lequel chacune de la pluralité de sections de carte de circuit imprimé (12x, 12y, 12z) comprend un IEPE (122x, 122y, 122z) incluant un IEPE transversal (122x) sur la section de carte de circuit imprimé transversale (12x), le site de connexion transversal (121x) étant connecté électriquement à une entrée IEPE du IEPE transversal (122x), un IEPE longitudinal (122y) sur la section de carte de circuit imprimé longitudinale (12y) qui amplifie et convertit de la charge électrique longitudinale (Cy) provenant de l'élément de mesure longitudinal (11y) en une tension de sortie longitudinale (Uy), le site de connexion longitudinal (121y) étant connecté électriquement à une entrée IEPE du IEPE longitudinal (122y), et un IEPE vertical (122z) sur la section de carte de circuit imprimé (12z) qui amplifie et convertit de la charge électrique verticale (Cz) provenant de l'élément de mesure vertical (11z) en une tension de sortie verticale (Uz), le site de connexion vertical (121z) étant connecté électriquement à une entrée IEPE du IEPE vertical (122z),
dans lequel, à l'étape III, la première connexion électrique de l'élément de mesure transversal (11x) au site de connexion transversal (121x) conduit électriquement de la charge électrique transversale (Cx) depuis l'élément de mesure transversal (11x) vers l'IEPE transversal (122x) qui amplifie et convertit la charge électrique transversale (Cx) en une tension de sortie transversale (Ux), la première connexion électrique de l'élément de mesure longitudinal (11y) au site de connexion longitudinal (121y) conduit électriquement de la charge électrique longitudinale (Cy) depuis l'élément de mesure longitudinal (11y) vers l'IEPE longitudinal (122y) qui amplifie et convertit la charge électrique longitudinale (Cy) en une tension de sortie longitudinale (Uy), et la première connexion électrique de l'élément de mesure vertical (11z) au site de connexion vertical (121z) conduit électriquement de la charge électrique verticale (Cz) depuis l'élément de mesure vertical (11z) vers l'IEPE vertical (122z) qui amplifie et convertit la charge électrique verticale (Cz) en une tension de sortie verticale (Uz).

11. Procédé selon l'une quelconque des revendications 2 à 10, dans lequel l'élément de connexion (14) comprend une pluralité de conducteurs de connecteur électrique (141x, 141y, 141z, 141g) incluant un conducteur de connecteur électrique transversal (141x), un conducteur de connecteur électrique longitudinal (141y), un conducteur de connecteur électrique vertical (141z) et un conducteur de connecteur électrique de masse (141g),
dans lequel la section de connecteur (12c) comprend une pluralité de zones de connexion (124x, 124y, 124z, 124g) incluant une zone de connexion transversale (124x), une zone de connexion longitudinale (124y), une zone de connexion verticale (124z) et une zone de connexion de masse (124g),
dans lequel, à l'étape IV, la connexion électrique supplémentaire (FEC) est réalisée entre le conducteur de connecteur électrique transversal (141x) et la zone de connexion transversale (124x), la connexion électrique supplémentaire (FEC) est réalisée entre le conducteur de connecteur électrique longitudinal (141y) et la zone de connexion longitudinale (124y), la connexion électrique supplémentaire (FEC) est réalisée entre le conducteur de connecteur électrique vertical (141z) et la zone de connexion verticale (124z), et la connexion électrique supplémentaire (FEC) est réalisée entre le conducteur de connecteur électrique de masse (141g) et la zone de connexion de masse (124g).

12. Procédé selon la revendication 11, dans lequel l'élément de connecteur (14) comprend un élément de boîtier de connecteur (140) et, à l'étape IV, un fil de masse de boîtier (116g) est prévu et une connexion électrique de masse (EGC) est réalisée en connectant électriquement l'élément de boîtier de connecteur (140) au moyen du fil de masse de boîtier (116g) au conducteur du connecteur électrique de masse (141g).

13. Capteur d'accélération piézoélectrique (1) comprenant un élément de boîtier (10) avec un élément de corps (103), une pluralité d'éléments de mesure (11x, 11y, 11z), un élément de carte de circuit imprimé flexible (12) et un élément de connecteur (14), ledit élément de boîtier (10) comprenant un espace intérieur (101) et un élément de corps (103) situé dans l'espace intérieur (101), ladite pluralité d'éléments de mesure (11x, 11y, 11z) mesurant une accélération le long d'une pluralité d'axes sensitifs (x, y, z) et générant une pluralité de charges électriques (Cx, Cy, Cz) pour l'accélération mesurée, ladite pluralité d'éléments de mesure (11x, 11y, 11z) étant fixée mécaniquement à l'élément de corps (103), ledit élément de carte de circuit imprimé flexible (12) présentant une pluralité d'IEPE (122x, 122y, 122z), chacun de la pluralité d'IEPE (122x, 122y, 122z) amplifiant et convertissant la charge électrique (Cx, Cy, Cz) provenant d'un élément de mesure associé parmi la pluralité d'éléments de mesure (11x, 11y, 11z) en une tension de sortie (Ux, Uy, Uz), ledit élément de carte de circuit imprimé flexible (12) établissant une tension de sortie de masse (Ug), ledit élément de carte de circuit imprimé flexible (12) étant fixé mécaniquement à l'élément de corps (103);
dans lequel l'élément de carte de circuit imprimé flexible (12) comprend une pluralité de sections de carte de circuit (12x, 12y, 12z), chacune des sections de carte de circuit (12x, 12y, 12z) présentant l'un de la pluralité des IEPE (122x, 122y, 122z), chacun de la pluralité d'éléments de mesure (11x, 11y, 11z) comportant une première connexion électrique (EC) à une section associée parmi la pluralité de sections de carte de circuit (12x, 12y, 12z), le nombre de premières connexions électriques (NE) étant égal au nombre d'axes sensitifs (x, y, z);
dans lequel l'élément de carte de circuit imprimé flexible (12) comprend une section de connecteur (12c) et l'élément de connecteur (14) comprend une connexion électrique supplémentaire (FEC) à la section de connecteur (12c), le nombre de connexions électriques supplémentaires (NFE) étant égal au nombre de la pluralité de tensions de sortie (Ux, Uy, Uz, Ug).

14. Capteur d'accélération piézoélectrique (1) selon la revendication 13, dans lequel la pluralité d'éléments de mesure (11x, 11y, 11z) comprend un élément de mesure transversal (11x) qui mesure une accélération le long de l'axe transversal (x) en tant qu'axe sensitif (x), un élément de mesure longitudinal (11y) qui mesure une accélération le long de l'axe longitudinal (y) en tant qu'axe sensitif (y) et un élément de mesure vertical (11z) qui mesure une accélération le long de l'axe vertical (z) en tant qu'axe sensitif (z);
dans lequel chacune de la pluralité de sections de carte de circuit imprimé (12x, 12y, 12z) comprend un site de connexion (121x, 121y, 121z) incluant un site de connexion transversal (121x), un site de connexion longitudinal (121y) et un site de connexion vertical (121z); et
dans lequel la première connexion électrique (EC) de l'élément de mesure transversal (11x) à un site de connexion transversal (121x) est réalisée par un fil d'élément de mesure transversal (115x), la première connexion électrique (EC) de l'élément de mesure longitudinal (11y) au site de connexion longitudinal (121y) est réalisée par un fil d'élément de mesure longitudinal (115y) et la première connexion électrique (EC) de l'élément de mesure vertical (11z) au site de connexion vertical (121z) est réalisée par un fil d'élément de mesure vertical (115z).

15. Capteur d'accélération piézoélectrique (1) selon l'une quelconque des revendications 13 ou 14, dans lequel l'élément de connecteur (14) comprend une pluralité de conducteurs de connecteur électrique (141x, 141y, 141z, 141g) incluant un conducteur de connecteur électrique transversal (141x), un conducteur de connecteur électrique longitudinal (141y), un conducteur de connecteur électrique vertical (141z) et un conducteur de connecteur électrique de masse (141g),
dans lequel la section de connecteur (12c) comprend une pluralité de zones de connexion (124x, 124y, 124z, 124g) incluant une zone de connexion transversale (124x), une zone de connexion longitudinale (124y), une zone de connexion verticale (124z) et une zone de connexion de masse (124g),
dans lequel la connexion électrique supplémentaire (FEC) est réalisée entre le conducteur de connecteur électrique transversal (141x) et la zone de connexion transversale (124x), la connexion électrique supplémentaire (FEC) est réalisée entre le conducteur de connecteur électrique longitudinal (141y) et la zone de connexion longitudinale (124y), la connexion électrique supplémentaire (FEC) est réalisée entre le conducteur de connecteur électrique vertical (141z) et la zone de connexion verticale (124z), et la connexion électrique supplémentaire (FEC) est réalisée entre le conducteur de connecteur électrique de masse (141g) et la zone de connexion de masse (124g).

16. Capteur d'accélération piézoélectrique (1) selon l'une quelconque des revendications 13 à 15, dans lequel l'élément de connecteur (14) comprend un élément de boîtier de connecteur (140) et la connexion électrique de l'élément de boîtier de connecteur (140) au conducteur de connecteur électrique de masse (141g) au moyen d'un fil de masse de boîtier (116g) établie une connexion électrique de masse (EGC).

17. Capteur d'accélération piézoélectrique (1) selon l'une quelconque des revendications 13 à 16, dans lequel la pluralité d'IEPE (122x, 122y, 122z) comprend un IEPE transversal (122x) qui amplifie et convertit une charge électrique transversale (Cx) provenant d'un élément de mesure transversal (11x) en une tension de sortie transversale (Ux), un IEPE longitudinal (122y) qui amplifie et convertit une charge électrique longitudinale (Cy) provenant d'un élément de mesure longitudinal (11y) en une tension de sortie longitudinale (Uy), et un IEPE vertical (122z) qui amplifie et convertit une charge électrique verticale (Cz) provenant d'un élément de mesure vertical (11x) en une tension de sortie verticale (Uz);
dans lequel l'élément de connecteur (14) comprend une pluralité de conducteurs de connecteur électrique (141x, 141y, 141z, 141g) incluant un conducteur de connecteur électrique transversal (141x), un conducteur de connecteur électrique longitudinal (141y), un conducteur de connecteur électrique vertical (141z) et un conducteur de connecteur électrique de masse (141g);
dans lequel la section de connecteur (12c) comprend une pluralité de zones de connexion (124x, 124y, 124z, 124g) incluant une zone de connexion transversale (124x), une zone de connexion longitudinale (124y), une zone de connexion verticale (124z) et une zone de connexion de masse (124g);
dans lequel la connexion électrique supplémentaire (FEC) est réalisée entre le conducteur de connecteur électrique transversal (141x) et la zone de connexion transversale (124x), la connexion électrique supplémentaire (FEC) est réalisée entre le conducteur de connecteur électrique longitudinal (141y) et la zone de connexion longitudinale (124y), la connexion électrique supplémentaire (FEC) est réalisée entre le conducteur de connecteur électrique vertical (141z) et la zone de connexion verticale (124z), et la connexion électrique supplémentaire est réalisée entre le conducteur de connecteur électrique de masse (141g) et la zone de connexion de masse (124g); et
dans lequel le conducteur de connecteur électrique transversal (141x) conduit électriquement la tension de sortie transversale (Ux), le conducteur de connecteur électrique longitudinal (141y) conduit électriquement la tension de sortie longitudinale (Uy), le conducteur de connecteur électrique vertical (141z) conduit électriquement la tension de sortie verticale (Uz) et le conducteur de connecteur électrique de masse (141g) conduit électriquement la tension de sortie de masse (Ug).

18. Capteur d'accélération piézoélectrique (1) selon la revendication 15, dans lequel l'élément de carte de circuit imprimé flexible (12) porte une pluralité de TEDS (123x, 123y, 123z), ladite pluralité de TEDS (123x, 123y, 123z) comprenant un TEDS transversal (123x) qui stocke de l'information transversale (Ix) concernant un élément de mesure transversal (11x) associé, un TEDS longitudinal (123y) qui stocke de l'information longitudinale (Iy) concernant un élément de mesure longitudinal (11y) associé et un TEDS vertical (123z) qui stocke de l'information verticale (Iz) concernant un élément de mesure vertical (11z) associé ; et
dans lequel le conducteur de connecteur électrique transversal (141x) conduit électriquement l'information transversale (Ix), le conducteur de connecteur électrique longitudinal (141y) conduit électriquement l'information longitudinale (Iy) et le conducteur de connecteur électrique vertical (141z) conduit électriquement l'information verticale (Iz).
